# EUROPÄISCHE PATENTSCHRIFT

(11) **EP 2 121 509 B1**
(45) Veröffentlichungstag und Bekanntmachung des Hinweises auf die Patenterteilung: **20.02.2019**
(21) Anmeldenummer: 07857609.7
(22) Anmeldetag: 14.12.2007
(51) Int. Cl.: B81B 1/00

(54) **VERKAPSELUNGSMODUL, VERFAHREN ZU DESSEN HERSTELLUNG UND VERWENDUNG**
ENCAPSULATION MODULE METHOD FOR PRODUCTION AND USE THEREOF
MODULE D'ENCAPSULAGE, PROCÉDÉ DE FABRICATION ET UTILISATION ASSOCIÉS

(30) Priorität: 21.12.2006 DE 102006060794; 14.12.2007 DE 102007060931
(43) Veröffentlichungstag der Anmeldung: 25.11.2009
(73) Patentinhaber: Continental Teves AG & Co. OHG, 60488 Frankfurt am Main (DE); Murata Electronics Oy, 01620 Vantaa (FI)
(72) Erfinder: SCHMID, Bernhard, 61169 Friedberg (DE); HILSER, Roland, 73230 Kirchheimteck (DE); KUISMA, Heikki, 00420 Helsinki (FI); TORKKELI, Altti, 04340 Tuusula (FI)
(86) Internationale Anmeldenummer: PCT/EP2007/063975
(87) Internationale Veröffentlichungsnummer: WO 2008/077821

(56) Entgegenhaltungen:
- EP-A- 1 353 373
- WO-A-02/073684
- WO-A-2005/061376
- DE-A1- 10 331 322

## Beschreibung

Die Erfindung betrifft ein Verkapselungsmodul oder eine mikromechanische Anordnung gemäß Oberbegriff von Anspruch 11, ein Herstellungsverfahren gemäß Oberbegriff von Anspruch 1 sowie die Verwendung solch eines Verkapselungsmoduls und/oder solch einer mikromechanischen Anordnung in Kraftfahrzeugen.

In Druckschrift EP 1 371 092 B1 wird ein Flächensubstrat aus Glas vorgeschlagen, welches Durchbrüche bzw. Durchführungen aus elektrisch leitendem Silizium aufweist.

Bei der Verwendung solch eines Flächensubstrats in einer mikromechanischen Anordnung werden üblicherweise Metallelektroden auf zumindest eine Basisfläche dieses Flächensubstrats aufgebracht, welche mit Durchführungen verbunden sind und als Kondensatorplatten mit mikromechanischen Strukturen zusammenwirken. Für elektrisch und mechanisch zuverlässige Übergangsverbindungen zwischen Silizium und einer Metallelektrode werden oftmals Elektroden aus wenigstens zwei Metallen verwendet.

Aufgrund der Kontaktierung verschiedener Materialien, insbesondere verschiedener Metalle und/oder kristallines beziehungsweise amorphes Silizium, kann es zu negativen Auswirkungen auf die Parameter der Bauteile wie beispielsweise ein hoher Temperaturgradient oder eine mangelhafte Langzeitstabilität kommen. Auch können sich parasitäre Effekte einschleichen, wie beispielsweise Elektro-Motorische-Kräfte (Batterie-Effekt), Elektromigration und Korrosion, insbesondere letzteres führt zu Problemen hinsichtlich der Langzeitstabilität der Bauteile.

In der EP 1 353 373 A2 ist ein Herstellungsverfahren offenbart mit der in ein Flächensubstrat aus Silizium weitere Durchgangskontakte eingearbeitet werden.

In der DE 103 31 322 A1 wird vorgeschlagen vertikale elektrische Durchkontaktierungen in einem Trägersubstrat auszubilden, auf dessen Oberfläche Bauelementstrukturen befestigt sind, wobei die Bauelementstrukturen mit Kontaktflächen verbunden sind, die über den Durchkontaktierungen angeordnet sind. Die Bauelementstrukturen und die Kontaktflächen sind in Hohlräumen angeordnet, welche bei der Direct Wafer Bonding des Trägersubstrats mit einer entsprechende Aushöhlungen aufweisenden Deckplatte gebildet werden.

In der Wo 2002/073684 und WO 2005/061376 sind weitere Verfahren zum Herstellen eines Flächensubstrats mit Durchgangskontaktierungen gezeigt.

Die Erfindung hat sich die Aufgabe gestellt, ein Verfahren zur Herstellung eines Verkapselungsmoduls oder einer mikromechanischen Anordnung und ein entsprechendes Verkapselungsmodul oder eine mikromechanische Anordnung vorzuschlagen, bei welchem auf Metallelektroden verzichtet werden kann und dadurch insbesondere obige Schwierigkeiten zumindest teilweise vermieden werden.

Die Aufgabe wird erfindungsgemäß gelöst durch das Herstellungsverfahren gemäß Anspruch 1 sowie das Verkapselungsmodul oder die mikromechanische Anordnung gemäß Anspruch 11.

Der Erfindung liegt insbesondere der Gedanke zu Grunde, ein Herstellungsverfahren sowie ein entsprechend hergestelltes Verkapselungsmodul oder eine mikromechanische Anordnung vorzuschlagen, welche zumindest eine Durchkontaktierung und wenigstens eine Halbleiter-Elektrode aus jeweils elektrisch leitendem Halbleitermaterial aufweist und diese in einem elektrisch im Wesentlichen nicht leitenden Einbettungsmaterial eingebettet sind.

Unter einer Elektrode und/oder Halbleiter-Elektrode wird bevorzugt ein Mittel eines kapazitiven Bauelements bzw. einer kapazitiven Anordnung bzw. eine Platte eines Plattenkondensators verstanden, welche/r insbesondere Teil einer mikromechanischen Ausleseeinrichtung und/oder Antriebseinrichtung ist. Alternativ vorzugsweise dient eine Elektrode und/oder Halbleiter-Elektrode als elektrisches Anschlussmittel bzw. Kontaktmittel.

Unter einer Ausleseeinrichtung wird zweckmäßigerweise eine Einrichtung verstanden, welche mindestens zwei Elektroden oder andere elektrische/elektronische Elemente aufweist, deren gemeinsame Kapazität/Kapazitätsänderungen im Verbund und/oder deren Potentialdifferenz zueinander gemessen wird. Insbesondere weist solch eine Auslesevorrichtung ineinander greifende, gegeneinander elektrisch im Wesentlichen isolierte, Leiterflächen/-platten auf, von denen eine an einem Basiselement, besonders bevorzugt an einem Rahmen und/oder einer oder mehreren seismischen Massen und/oder an einem Kopplungsbalken befestigt ist, und die andere an einem mikromechanischen Modul bzw. Wafer. Eine Auslesevorrichtung weist insbesondere ein Elektrodenpaar auf.

Unter einer Antriebseinrichtung wird vorzugsweise ein kapazitiver Antrieb mit mindestens zwei gegenüberliegenden Leiterflächen, insbesondere Kondensatorplatten, verstanden, von denen eine mit mindestens einem Basiselement und/oder einer seismischen Masse und die andere mit einem mikromechanischen Modul bzw. Wafer verbunden ist. Durch Anlegen einer Differenzspannung an diese Leiterflächen können diese gegeneinander bewegt werden. Mittels mindestens einer Antriebseinheit wird insbesondere eine Antriebsmode eines Sensorelements, wie beispielsweise eines Drehratensensorelements, erzeugt.

Unter einem Modul, insbesondere einem Verkapselungsmodul, Trägermodul oder einem Strukturmodul, wird bevorzugt ein mikromechanisches Mittel verstanden, welches selbst ein mikromechanisches System und/oder eine mikromechanische Struktur ist oder welches in Kombination mit anderen Modulen zu einem mikromechanischen System ergänzt werden kann. Bevorzugt sind solche Module Wafermodule, welche entsprechend den jeweiligen Anforderungen hergestellt werden und ausgebildet sind.

Unter einem Strukturierungsprozess wird bevorzugt ein Ätzprozess verstanden, welcher besonders bevorzugt ein nasschemisches Ätzen, insbesondere mittels KOH (Kaliumhydroxid) oder anisotropes Ätzen mittels TMAH (Tetra Methyl Ammonium Hydroxid), und/oder ein anisotropes Trocken-Ätzen, insbesondere Ion-Milling oder ein Elektrodenstrahlverfahren und/oder ein anisotrop reaktives Ionenätzen, wie insbesondere DRIE (Deep Reaktive Ion Etching), wie beispielsweise ein Ätz-Passivierungs-Verfahren, insbesondere mit Polymere-Passivierungs-Zwischenschritten, und/oder ein gyrostatisches Ätzverfahren umfasst.

Weitere Strukturierungsprozesse umfassen alternativ vorzugsweise ein mechanisches Bearbeitungsverfahren wie insbesondere Fräsen und/oder Sägen.

Im Rahmen des Verfahrens werden zweckmäßigerweise ein oder mehrere Ätzprozesse durchgeführt und insbesondere kein mechanischer Prozess zur Ausbildung der elektronischen Anschlussmittel, da mechanische Prozesse normalerweise nur relativ große Strukturierungsbreiten zulassen und insbesondere eine rasterförmige Ausbildung erzeugen, wie beispielsweise durch Sägespuren.

Die Verbindung bzw. das Aneinanderfügen von mindestens zwei mikromechanischen Modulen bzw. der Siliziumwafer erfolgt bevorzugt mittels wenigstens eines Waferbondverfahrens. Dabei wird besonders bevorzugt zumindest ein anodisches Glas-Silizium-, anodisches Glas-Aluminium-, Lot-, Fusions-, eutektisches Metall-, Klebe-Bonden oder andere geeignete Waferfügeverfahren genutzt. Ganz besonders bevorzugt wird ein Fusions-Bonden der beiden mikromechanischen Module, wie beispielsweise einem Strukturmodul, insbesondere umfassend wenigstens ein Sensorelement, und einem Verkapselungsmodul, unter einer O₂-Atmosphäre durchgeführt, so dass bei dem Hochtemperaturprozess das O₂ mit dem Silizium reagiert und sich eine Siliziumoxidschicht auf der Oberfläche innerhalb mindestens einer durch den Bondprozess eingeschlossene Kavität des Strukturmoduls bildet. Diese dient insbesondere beim anschließenden Strukturätzen als Ätzstoppschicht.

Vorzugsweise wird mittels einer lokalen Oxidation bzw. einem LOCOS-Prozess (Local Oxidation of Silicon) ein Spalt zwischen zwei mikromechanischen Modulen, insbesondere einem Strukturmodul und einem Verkapselungsmodul, erzeugt.

Es ist bevorzugt, zwischen den beiden mikromechanischen Modulen eine Fügeschicht aus isolierendem oder leitfähigem Material einzubringen, welche die beiden Module bzw. Wafer entweder isolierend oder elektrisch leitfähig miteinander verbindet. Hierbei können, über mehrere selektive Strukturierungs- und Abscheideverfahren der Fügeschicht, lokal isolierende oder elektrisch leitende Fügeflächen erzeugt werden.

Die vorgeschlagene Technologie weist, weiter oben beschriebene, aus dem Stand der Technik bekannte, Probleme nicht oder nur in geringerem Umfang auf. Insbesondere wird dies dadurch erreicht, dass die Technologie flexibel an die Anforderungen der Applikation angepasst werden kann (Baukastensystem). Bevorzugt geeignet ist sie für Inertialsensoren, wie Beschleunigungs-, Drehraten-, Drucksensoren, mit kapazitiver Wandlung mechanischer Bewegungen in elektrische Signale und umgekehrt. Aufgrund der Flexibilität der vorgeschlagenen Technologie besteht besonders bevorzugt die Möglichkeit zur Integration von verschiedenen Applikationen auf einem Stück Silizium. Sollte eine direkte Chip-Integration, beispielsweise auf einem ASIC, nicht möglich sein, so wird es durch die vorgeschlagene Technologie insbesondere ermöglicht, auch andere Bauteile präzise und ohne Verdrahtungsaufwand in ein gemeinsames Gehäuse einzubauen und von außen anzuschließen.

Das elektrisch leitende Halbleitermaterial ist vorzugsweise dotiertes, kristallines beziehungsweise amorphes Silizium.

Die wenigstens eine Durchkontaktierung ist bevorzugt als elektrische Leitung und/oder als Wärmeleitpfad ausgebildet.

Es ist im Rahmen des Verfahrens zweckmäßig, dass während des Einbettens der elektronischen Anschlussmittel mit dem Einbettungsmaterial und/oder während des anschließenden Aushärtens des Einbettungsmaterials, das Einbettungsmaterial zu einem im Wesentlichen scheibenförmigen Körper ausgebildet wird, in welchem die elektronischen Anschlussmittel eingebettet sind. Dabei umfasst der Einbettungsvorgang insbesondere zumindest einen Gieß- und/oder Schmelzvorgang. Insbesondere geschieht das Formen des scheibenförmigen Körpers durch eine Form, welche den Sockel des Halbleitermaterials aufnimmt oder an diesen angrenzt, so dass die elektronischen Anschlussmittel innerhalb der Form angeordnet sind und beim Einfüllen des Vergussmaterials in die Form, vom Vergussmaterial eingebettet werden. Alternativ vorzugsweise wird das Vergussmaterial in eine "Form" gegossen, welche aus dem Sockel des Rohmaterials als Boden und einem schmalen Rand des Rohmaterials als Wänden besteht. Dieser schmale, umlaufende Rand des Rohmaterials wird zuvor während des wenigstens einen Ätz- und/oder Strukturierungsprozesses, bei welchem auch die elektronischen Anschlussmittel ausgebildet werden, zu diesem Zweck ausgebildet.

Unter einem im Wesentlichen scheibenförmigen Körper wird vorzugsweise ein Körper mit zwei im Wesentlichen zueinander parallelen Basisflächen, also einer Grund- und einer Deckfläche, verstanden. Dabei kann die Körperdicke, also der Abstand zwischen den Basisflächen insbesondere größer sein als die Länge und/oder die Breite bzw. der Durchmesser einer Basisfläche des scheibenförmigen Körpers. Besonders bevorzugt ist der scheibenförmige Körper allerdings flach ausgebildet, dass heißt der Körperdicke ist geringer als die Länge oder die Breite bzw. der Durchmesser einer Basisfläche des scheibenförmigen Körpers.

Es ist zweckmäßig, dass im Rahmen des Verfahrens mindestens eine der Außenflächen des Verkapselungsmoduls mit einem leitfähigen Material beschichtet wird. Insbesondere ist dieses ein Metall, welches aufgedampft oder mittels eines Sputterverfahrens aufgebracht wird. Unter der leitfähigen Schicht ist besonders bevorzugt eine elektrisch isolierende Schicht ausgebildet, welche die leitende Schicht außer an zumindest einem elektronischen Anschlussmittel von der entsprechenden Basisfläche des Verkapselungsmoduls elektrisch isoliert. Ganz besonders bevorzugt wird die leitfähige Schicht, insbesondere auch ohne das Vorhandensein einer oben beschriebenen isolierenden Schicht, anschließend strukturiert und bildet dabei Kontaktierungen bzw. Kontaktpads aus, über welche zumindest eine Seite wenigstens einer Durchkontaktierung elektrisch anschließbar ist, insbesondere mittels eines Bondrahts bzw. anderer in der Halbleiter-Technik bekannter Kontaktierungsverfahren wie beispielsweise mittels Lötkugeln (Ball-Grid-Array) und/oder einer Flip-Chip-Assemblierung.

Es ist bevorzugt, das Verfahren so zu erweitern, dass auf mindestens einer Außenfläche des Verkapselungsmoduls elektronische und/oder mechanische Mittel, wie elektrische Kontaktelemente, Pufferelemente, Stopperelemente oder Kavitäten, zum passgenauen Anschluss des Verkapselungsmoduls an mindestens eine mikromechanische Struktur und/oder mindestens ein weiteres mikromechanisches Modul aufgebracht werden. Insbesondere wird zwischen Verkapselungsmodul und einem Strukturmodul ein Quetschkontakt erzeugt, welcher aus einer metallischen Schicht eines der Module durch Druck und Wärme entsteht. Solch ein Quetschkontakt dient zur Kontaktierung zwischen Durchkontaktierung und Struktur. Dieser Quetschkontakt wird besonders bevorzugt bei einem Anker oder einer Säule des Strukturmoduls erzeugt.

Auf der zur Verkapselung vorgesehenen Basisfläche des Verkapselungsmoduls wird vorzugsweise zumindest teilweise elektrisch isolierendes Material aufgebracht. Dieses Material wird so ausgebildet und angeordnet, dass es als mechanisches Mittel wie beispielsweise ein Überlastanschlag und/oder einStopper für eine zu verkapselnde mikromechanische Struktur bzw. ein mikromechanisches Sensorelement eingesetzt werden kann. Wenigstens ein solches mechanisches Mittel wird besonders bevorzugt auf bzw. unter einer Halbleiter-Elektrode befestigt bzw. angeordnet.

Das eine oder die mehreren mechanischen Mittel werden/sind bevorzugt aus elektrisch isolierendem Material, insbesondere Siliziumoxid oder -nitrid oder Diamond Like Carbon (DLC) oder Kombinationen dieser Materialien ausgebildet.

Es ist zweckmäßig, dass in Rahmen des Verfahrens, Glas als Vergussmaterial verwendet wird und dass das Glas über den elektronischen Anschlussmitteln schmelzend vergossen oder als flüssiges Glas direkt vergossen und anschließend ausgehärtet wird.

Vorzugsweise wird das Verfahren dadurch ergänzt, dass mittels wenigstens eines Strukturierungsprozesses und/oder Ätzprozesses mindestens ein Tunnel zwischen zumindest zwei, insbesondere gegenüberliegenden, Außenflächen des Verkapselungsmoduls erzeugt wird. Besonders bevorzugt wird der mindestens eine Tunnel durch Entfernen mindestens einer Durchkontaktierung, welcher insbesondere keine Halbleiter-Elektrode zugeordnet ist, erzeugt.

Es ist zweckmäßig, dass das Verfahren dahingehend ergänzt wird, dass mindestens eine zusätzliche mikromechanische Struktur bzw. wenigstens ein Strukturmodul durch das Verkapselungsmodul, insbesondere hermetisch bzw. gasdicht, verkapselt wird, wobei, insbesondere vor dem Verkapseln, mindestens eine elektrische Durchkontaktierung des Verkapselungsmoduls, der insbesondere keine Halbleiter-Elektrode zugeordnet ist, beispielsweise mittels eines Ätzprozesses, entfernt wird. Dabei entsteht zumindest ein Tunnel durch das Verkapselungsmodul in den Innenraum der entsprechenden mikromechanischen Struktur bzw. des Strukturmoduls. Nachfolgend wird durch diese/n Tunnel, insbesondere jeweils, ein definiertes Medium mit definiertem Druck in den jeweiligen Innenraum der entsprechenden mikromechanischen Struktur eingebracht. Es kann insbesondere ebenfalls ein Medienaustausch mittels des Tunnels erfolgen. Durch diese Vorgehensweise kann in einem oder mehreren Strukturräumen eine definierte Atmosphäre eingestellt werden. Dies ist insbesondere deshalb vorteilhaft, da unterschiedliche Sensorelemente bzw. Sensorelementtypen verschiedene Anforderungen an die Atmosphäre des Strukturraums, beispielsweise hinsichtlich des Medium und des Drucks, aufweisen. Durch obiges Verfahren können besonders bevorzugt relativ einfach mehrere unterschiedliche Strukturen bzw. Sensorelemente auf einem gemeinsamen Chip integriert werden. Dazu werden ganz besonders bevorzugt mehrere Strukturräume mit wenigstens einem Verkapselungsmodul verkapselt, welches mehrere Tunnel, insbesondere jeweils zumindest einen Tunnel pro Strukturraum, aufweist. Durch einen oder mehrere offene Tunnel werden außerdem insbesondere Ein- bzw. Auslässe für Drucksensoren, Flüssigkeitskanäle, Pumpen oder Ventile erzeugt.

Es ist dabei zweckmäßig, dass der mindestens eine Tunnel anschließend verschlossen wird. Besonders bevorzugt wird das anschließende Verschließen des mindestens einen Tunnels durch Einbringen eines Einbettungs- und/oder Vergussmaterials in diesen mindestens einen Tunnel und danach erfolgendem Aushärten dieses Materials durchgeführt.

Vorzugsweise wird mindestens eine Halbleiter-Elektrode mittels zumindest eines Strukturierungs- und/oder Ätzprozesses zumindest teilweise entfernt, wodurch eine Kavität auf einer Basisfläche des Verkapselungsmoduls erzeugt wird und insbesondere ein restlicher Teil der Halbleiter-Elektrode als Kondensatorplatte oder Kontaktierung verfügbar ist. Diese Kavität dient beispielsweise als Raum zum Auslenken einer mikromechanischen Struktur.

Die Entfernung wenigstens einer Durchkontaktierung, welcher insbesondere keine Halbleiter-Elektrode zugeordnet ist, zur Ausbildung eines Tunnels oder die zumindest teilweise Entfernung einer Halbleiter-Elektrode zur Ausbildung einer Kavität erfolgt bevorzugt durch einen KOH-, TMAH- und/oder anderen Ätzprozess.

Im Zuge der Ausbildung der elektronischen Anschlussmittel werden vorzugsweise zunächst wenigstens eine oder mehrere Elektroden und/oder Kontaktflächen und/oder Leiterbahnen aus dem Rohkörper elektrisch leitenden Halbleitermaterials durch im Wesentlichen senkrechtes Ätzen und/oder alternatives Strukturieren, wie beispielsweise mittels Fräsen, auf dem Sockel ausgebildet. Zumindest eine Leiterbahn ist dabei insbesondere als Querverbindung zwischen zwei oder mehr Elektroden ausgebildet. Hiernach erfolgt die Ausbildung der einen oder mehreren Durchkontaktierungen, welche besonders bevorzugt als Säulen auf Elektroden und/oder Kontaktflächen und/oder Leiterbahnen ausgebildet sind. Anschließend werden diese elektronischen Anschlussmittel mit Einbettungsmaterial, vorzugsweise Glas, eingebettet.

Es ist bevorzugt, dass das Verkapselungsmodul oder die mikromechanische Anordnung so ausgebildet ist, dass der scheibenförmig ausgebildete Körper mindestens einen Tunnel zwischen den beiden äußeren Basisflächen aufweist. Dabei ist dieser mindestens eine Tunnel offen oder mit Einbettungsmaterial oder einem anderen Material verschlossen. Durch einen geöffneten Tunnel werden besonders bevorzugt eine definierte Atmosphäre in einen Strukturinnenraum eines Strukturmoduls und/oder Ein- bzw. Auslässe für Drucksensoren, Flüssigkeitskanäle, Pumpen oder Ventile bereitgestellt.

Es ist zweckmäßig, dass das Verkapselungsmodul oder die mikromechanische Anordnung mindestens eine Halbleiter-Elektrode aus elektrisch leitenden Halbleitermaterial aufweist, welche eine Grenzfläche mit einer der Basisflächen des scheibenförmig ausgebildeten Körpers aufweist, und im Wesentlichen hügelförmig in den scheibenförmig ausgebildeten Körper hinein ausgedehnt ausgebildet ist und innerhalb dieses Körpers mit einer Durchkontaktierung, insbesondere einstückig, verbunden ist.

Wenigstens eine Halbleiter-Elektrode, die mit einer Durchkontaktierung verbunden ist, wird alternativ vorzugsweise als relativ großflächiges elektrisches Kontaktelement bzw. elektrischer Kontakt verwendet und besonders bevorzugt mittels eines Bonddrahts kontaktiert.

Vorzugsweise wird als Einbettungsmaterial für das Verkapselungsmodul oder die mikromechanische Anordnung Glas oder ein polymeres Material, insbesondere Harz, verwendet. Die Verwendung von Glas ermöglicht insbesondere anodisches Bonden mit Silizium.

Es ist bevorzugt, dass der scheibenförmig ausgebildete Körper des Verkapselungsmoduls oder der mikromechanischen Anordnung an mindestens einer Stelle, auf mindestens einer der beiden äußeren Basisflächen, mit einem leitfähigen Material beschichtet ist. Besonders bevorzugt ist die leitfähige Materialschicht so strukturiert, dass einzelne ihrer Segmente mit Durchkontaktierungen verbunden sind und somit Kontaktierungen bzw. Kontaktpads, insbesondere aus Metall, ausbilden. Ganz besonders bevorzugt ist zumindest eine Durchkontaktierung an einem Ende einer Halbleiter-Elektrode zugeordnet bzw. mit dieser einstückig verbunden, wobei diese bündig in das Verkapselungsmodul eingebettet ist, und auf der anderen Seite ist dieser Durchkontaktierung eine, insbesondere eine obig beschriebene, Metallkontaktierung, zugeordnet bzw. ist sie mit dieser elektrisch leitend verbunden.

Das Verkapselungsmodul oder die mikromechanische Anordnung weist vorzugsweise mindestens eine Leiterbahn aus elektrisch leitendem Halbleitermaterial auf, welche mit einer Basisfläche eine gemeinsame Halbleiter-Leiterbahnfläche aufweist und insbesondere entsprechend der mindestens einen Halbleiter-Elektrode ausgebildet ist. Diese zumindest eine Halbleiter-Leiterbahn ist besonders bevorzugt mit wenigstens einer Durchkontaktierung und/oder einer Halbleiter-Elektrode verbunden. Alternativ vorzugsweise ist sie lediglich als Halbleiter-Leiterbahn zur Kontaktierung auf einer Basisfläche ausgebildet und weist keine zusätzliche Verbindung zu einer Durchkontaktierung auf. Die wenigstens eine Halbleiter-Leiterbahn ist ganz besonders bevorzugt entsprechend einer Halbleiter-Elektrode ausgebildet und angeordnet und weist dabei allerdings eine größere Ausdehnung in einer Ebene parallel zur Basisfläche als eine Halbleiter-Elektrode auf. Auf der mindestens einen Halbleiter-Leiterbahn sind zweckmäßigerweise eine oder mehrere Halbleiter-Elektroden angeordnet bzw. diesen zugeordnet und mit diesen leitend verbunden.

Die wenigstens eine Halbleiter-Elektrode und/oder die zumindest eine Halbleiter-Leiterbahn sind dabei zweckmäßigerweise bündig mit der entsprechenden Basisfläche ausgebildet und bilden somit im Wesentlichen keine Erhebung und/oder Vertiefung auf dieser Basisfläche aus.

Die mindestens eine Halbleiter-Leiterbahn verbindet bevorzugt zumindest zwei Halbleiter-Elektroden.

Es ist bevorzugt, dass zumindest eine Halbleiter-Elektrode als elektrisch leitfähige Fläche, insbesondere Kondensatorplatte, einer mikromechanischen Ausleseeinrichtung und/oder Anrege-/Antriebseinrichtung oder als elektrisches Anschlussmittel ausgelegt ist.

Das Verkapselungsmodul weist zweckmäßigerweise einen Rahmen aus leitfähigem Halbleitermaterial auf. Dieser dient insbesondere zur Aufnahme des Einbettungsmaterials. Besonders bevorzugt dient dieser Rahmen als elektromagnetische Schirmung. Der Rahmen wird insbesondere zusätzlich oder alternativ, im Fall, dass mehrere Verkapselungsmodule auf bzw. aus einem gemeinsamen Wafer bzw. Trägerwafer ausgebildet sind, als Sägespur zum Trennen der Verkapselungsmodule voneinander verwendet, was vorteilhaft ist, da das Einbettungsmaterial, wie beispielsweise Glas, relativ schlecht zu sägen ist. Außerdem können die Rahmen der Verkapselungsmodule hinsichtlich des gemeinsamen Wafers zu mechanischen Versteifung dienen, insbesondere im Fall, dass der Wafer größtenteils bis auf die jeweilige Sockelhöhe zurückgedünnt bzw. abgetragen ist.

Vorzugsweise weist der scheibenförmig ausgebildete Körper an mindestens einer der beiden äußeren Basisflächen mindestens ein mikromechanisches Mittel, wie ein Pufferelement ein Stopperelement, einen mechanischen Überlastanschlag, insbesondere aus elektrisch isolierendem Material, oder eine Kavität, zum Zusammenwirken mit zusätzlichen mikromechanischen Strukturen, auf. Dabei ist besonders bevorzugt zumindest ein Puffer- und/oder Stopperelement aus elektrisch leitendem oder isolierendem Halbleitermaterial ausgebildet und auf zumindest einer Halbleiter-Elektrode ausgebildet.

Es ist zweckmäßig, dass der scheibenförmig ausgebildete Körper des Verkapselungsmoduls oder der mikromechanischen Anordnung mit mindestens einer zusätzlichen mikromechanischen Struktur bzw. einem Strukturmodul so verbunden ist, dass dieser die zusätzliche/n mikromechanische/n Struktur/en, insbesondere hermetisch bzw. gasdicht, verkapselt und dass elektrische Anschlüsse und/oder Kontakte der zusätzlichen mikromechanischen Struktur/en mit einer oder mehreren Durchkontaktierungen und/oder Halbleiter-Elektroden und/oder Halbleiter-Leiterbahnen, und optionalen weiteren elektrischen Anschlussmitteln, welche in dem scheibenförmig ausgebildeten Körper eingebettet sind, elektrisch leitend verbunden sind und/oder elektrisch zusammenwirken.

Vorzugsweise ist das mindestens eine mikromechanische Mittel, auf mindestens einer der beiden äußeren Basisflächen des scheibenförmig ausgebildeten Körpers so angeordnet und ausgebildet, dass dieses/diese mit den mikromechanischen Mitteln der mindestens einen zusätzlichen mikromechanischen Struktur, wie Membranen oder Biegebalken, zusammenwirken kann/ können.

Es ist zweckmäßig, dass die mindestens eine zusätzliche mikromechanische Struktur über die mindestens eine elektrische Durchkontaktierung und/oder Halbleiter-Elektrode und/oder Halbleiter-Leiterbahn, welche in dem scheibenförmig ausgebildeten Körper eingebettet ist/sind, an mindestens eine externe, insbesondere integrierte, elektronische Schaltung elektrisch angeschlossen ist/sind. Besonders bevorzugt ist/sind die mindestens eine zusätzliche mikromechanische Struktur über den scheibenförmig ausgebildeten Körper mit mindestens einer, insbesondere auf einem Chip, integrierten Schaltung mechanisch verbunden.

Verzugsweise ist der scheibenförmig ausgebildete Körper mechanisch und/oder mittels mindestens einer in diesem eingebetteten Durchkontaktierungen und/oder Halbleiter-Elektroden und/oder Halbleiter-Leiterbahnen elektrisch leitend mit mindestens einer zusätzlichen mikromechanischen Struktur bzw. Strukturmodul und/oder mindestens einer zusätzlichen mikromechanischen Anordnung und/oder mindestens einer, insbesondere auf einem Chip angeordneten, integrierten Schaltung, insbesondere mittels zusätzlicher Lötperlen, verbunden. Besonders bevorzugt ist die mindestens eine zusätzliche mikromechanische Struktur und/oder die mindestens eine zusätzliche mikromechanische Anordnung und/oder die mindestens eine, insbesondere auf einem Chip, integrierte Schaltung mit einer Basisfläche des scheibenförmig ausgebildeten Körpers mechanisch und/oder elektrisch leitend mittels wenigstens einer Durchkontaktierung und/oder Halbleiter-Elektrode und/oder Halbleiter-Leiterbahn verbunden und dass die andere Basisfläche des scheibenförmig ausgebildeten Körpers mit einer Leiterplatine oder einer zusätzlichen elektronischen Schaltung oder einem zusätzlichen Verkapselungsmodul, ganz besonders bevorzugt über Lötperlen, beispielsweise über ein Raster aus Lötperlen, verbunden.

Es ist zweckmäßig, dass der scheibenförmig ausgebildete Körper auf einem Sensorgehäuse als Deckel angeordnet und befestig ist, wobei mindestens eine im Sensorgehäuse angeordnete elektronische Schaltung und/oder mindestens ein elektronisches Bauelemente und/oder mindestens eine mikromechanische Struktur bzw. Strukturmodul über die mindestens eine, in dem scheibenförmig ausgebildeten Körper eingebettete, elektrische Durchkontaktierung und/oder Halbleiter-Elektrode und/oder Halbleiter-Leiterbahn an mindestens eine externe elektronische Schaltung elektrisch leitend angeschlossen ist. Besonders bevorzugt ist der scheibenförmige Körper mit einem Lack oder einem Kunststoff gegenüber dem Sensorgehäuse abgedichtet.

Die mikromechanische Anordnung umfasst vorzugsweise einen oder mehrere Drehratensensorelemente und/oder einen oder mehrere Beschleunigungssensorelemente. Insbesondere sind zumindest zwei Sensorelemente bezüglich ihrer Erfassungsrichtungen im Wesentlichen orthogonal zueinander angeordnet. Besonders bevorzugt umfasst die mikromechanische Anordnung zwei oder drei Sensorelemente desselben Typs, welche bezogen auf ihre Erfassungsrichtung im Wesentlichen orthogonal zueinander angeordnet sind, sowie mindestens ein Sensorelementpaar desselben Typs, welche ebenfalls bezüglich ihrer Erfassungsrichtungen orthogonal zueinander angeordnet sind. Ganz besonders bevorzugt umfasst die mikromechanische Anordnung drei Drehratensensorelemente und drei Beschleunigungssensorelemente, welche insbesondere eine inertiale Messeinheit (IMU) mit sechs Freiheitsgraden bilden. Insbesondere zusätzlich oder alternativ vorzugsweise umfasst die mikromechanische Anordnung redundante Sensorelemente.

Die mikromechanische Anordnung umfasst zweckmäßigerweise, insbesondere zusätzlich, eine oder mehrere elektronische Schaltungen und/oder Bauelemente, wie beispielsweise ein ASIC, eine Sende- und/oder eine Empfangseinheit bzw. eine Antennenstruktur.

Unter einem elektronischen bzw. elektrischen Anschlussmittel wird bevorzugt eine Durchkontaktierung, eine elektrische Leitung, ein Kontakt, eine Halbleiter-Elektrode, eine Halbleiter-Leiterbahn und/oder andere elektronische/elektrische Strukturen und/oder Bauelemente verstanden.

Nachstehend sind einzelne bevorzugte Fertigungsschritte der Fertigungstechnologie und deren mögliche Alternativen beschrieben, aus denen sich ein Baukastensystem zur Herstellung einer mikromechanischen Anordnung zusammensetzt. Vorzugsweise besteht eine mikromechanische Anordnung bzw. eine verkapselte Struktur aus einem oder mehreren Strukturmodulen und einem oder mehreren Verkapselungsmodulen. Durch die Verkapselungsmodule wird die Struktur im sogenannten Strukturraum bzw. Strukturinnenraum eingeschlossen.

Dabei werden alternativ vorzugsweise zwei Varianten, K und B, vorgeschlagen. Bei Variante L ist ein Strukturmodul bzw. Strukturwafer, insbesondere ausschließlich dessen Unterseite, mit einer Ätzstoppschicht überzogen, während dies bei Variante K nicht der Fall ist. Der Vorteil von Variante L ist, dass bei einem späteren Trench-Ätzen, die Ätzung auf dem Oxid gestoppt wird und somit eine Unterätzungen oder Unterschneidung der erzeugten Struktur verhindert wird. Die Oxidschicht kann auch beim Bonden der Wafer erzeugt werden.

Ein weiterer alternativer Herstellungsprozess eines Strukturmoduls, ist bevorzugt das Zusammenfügen eines vorprozessierten Strukturmoduls bzw. Strukturwafers mit einem, vorzugsweise einfachen, unstrukturierten und insbesondere oxidierten Trägerwafer. Auch hier sind die beiden oben angesprochenen Varianten K und L alternativ vorzugsweise (mit oder ohne Oxidfilm überzogener Strukturwafer) denkbar. Damit lassen sich zusätzliche Strukturkonzepte realisieren, wie beispielsweise aus der Strukturebene ausgelagerte Massenschwerpunkte und/oder die Einstellung der Membrandicke durch anisotropes Ätzen (trocken, naßchemisch) der Kavitäten. Der Abstand zum Trägerwafer, durch welchen die Struktur freigestellt ist, kann mit ähnlichen Verfahren, wie LOCOS oder DRIE oder anderen anisotropen Ätzverfahren in den Strukturwafer und/oder den Trägerwafer selber eingebracht werden. Vorteile dieses Herstellungsverfahrens im Vergleich zu oben beschriebenem Verfahren, ist die Einstellung einer frei definierbaren Strukturhöhe unter Verwendung handelsüblicher kostengünstiger Waferdicken, die Vermeidung von Waferrückdünnprozessen und das Herstellen von Strukturen innerhalb der Kavität.

Das Verkapselungsmodul lässt zweckmäßigerweise alle Möglichkeiten der Waferverbindungstechnolgien zu und ermöglicht gleichzeitig die Herausführung elektrischer Signale aus dem Strukturraum und besonders bevorzugt den Einschluss von verschiedenen Medien innerhalb der Strukturräume auf einem Wafer, beziehungsweise innerhalb eines MEMS-Systems.

Dabei betrifft das Verfahren zur Herstellung des Verkapselungsmoduls alternativ vorzugsweise ein Verfahren, welches vertikale elektrische Anschlüsse mit integrierten Silizium-Halbleiter-Elektroden erzeugt und/oder ein Verfahren, wobei Mittel erzeugt werden, mit denen selektive Medienbedingungen im Strukturraum eingestellt werden können. Insbesondere werden nach dem Aufbringen von Stoppern, beide Seiten des Verkapselungsmoduls beschichtet, mit Ausnahme der Stellen, bei denen eine Öffnung von einer zur anderen Deckelseite erzeugt oder belassen werden soll.

Alternativ vorzugsweise zu einigen, der im späteren Verlauf dargestellten Ausführungsbeispielen der hermetischen Verkapselung von Struktur- und Verkapselungsmodul, kann die Bondfläche, insbesondere zwischen Struktur- und Verkapselungsmodul, auch identisch zu den Halbleiter-Elektroden aus Silizium hergestellt werden. In diesem Fall erfolgt das Bonden über einen Fusions-Bond-Prozess. Hierbei ist jedoch besonders bevorzugt darauf zu achten, dass die Bondtemperatur nicht die kritische Temperatur für das Vergussmaterial übersteigt. Ganz besonders bevorzugt wird deshalb ein plasmaaktiviertes "Fusions-Bonden" verwendet. In beiden Fällen ist zweckmäßigerweise darauf zu achten, dass die Durchkontaktierungen mittels Halbleiter-Elektroden einen elektrisch leitenden Kontakt zu der Struktur bilden. Dies kann durch eine leitende Fügeschicht zwischen den Fügeflächen von Verkapselungsmodul und Strukturmodul erreicht werden. Die leitende, insbesondere relativ dünne, Fügeschicht ist auf mindestens eine der beiden Grenzflächen, des Verkapselungsmoduls und/oder des Strukturmoduls, aufgebracht. Durch die relativ hohen Temperaturen beim Fusionsbond-Prozess diffundiert das Metall in beide Grenzflächen aus Silizium, wodurch sich eine Grenzschicht dotierten Siliziums ausbildet, welche elektrisch leitend ist und wodurch besonders bevorzugt elektrische Kontakte zwischen mindestens jeweils einer Durchkontaktierung und einem elektrischen Kontakt des Strukturmoduls entstehen.

Bei Durchführung eines anodischen Bond-Verfahrens wird dagegen bevorzugt durch die elektrostatische Kraft während des Prozesses ein relativ großer mechanischer Druck ausgeübt, welcher in Kombination mit der den Prozess begleitenden Temperaturentwicklung einen leitfähigen "Quetschkontakt" aus einer Metallschicht auf der Fügefläche mindestens eines der Module erzeugt. Durch solch einen Quetschkontakt wird ebenfalls ein elektrischer Kontakt zwischen Verkapselungsmodul, insbesondere einer Durchkontaktierung und mindestens einem elektrisch leitenden Mittel des Strukturmoduls hergestellt.

Bezüglich der beidseitigen, hermetischen Verkapselung zumindest eines Strukturmoduls mit Verkapselungsmodulen, ist es bei Betrachtung der Technologiefolge zweckmäßig, dass man neben einem Trägermodul auch ein zweites Verkapselungsmodul verwenden kann. Dabei erfolgt zunächst vorzugsweise ein Elektroden-Gap-Prozess auf dem unbehandelten Strukturwafer bzw. dem Strukturmodul, dann erfolgt das Bonden gegen ein Verkapselungsmodul mit Halbleiter-Elektroden und anschließend das Zurückdünnen des Strukturmoduls bzw. des Strukturwafers, gefolgt von einem zweiten Gap-Prozess mit anschließendem Strukturätzen und Bonden des zweiten Verkapselungsmoduls. Es ist die Befüllung mittels mindestens eines Tunnels mit dem gleichen Medium innerhalb aller Strukturräume oder das selektive Befüllen der einzelnen Strukturräume besonders bevorzugt.

Zur Erzeugung einer mikromechanischen Anordnung umfassend wenigstens eine verkapselte Struktur, die zumindest ein Strukturmodul und wenigstens ein Verkapselungsmodul aufweist, und mindestens eine Regelungs- und Signalauswerteschaltung (ASIC) wird vorzugsweise eine einfache Assemblierung in einem vorgeformten Gehäuse mittels Drahtbonden durchgeführt. Die Anordnung von verkapselten Strukturen und insbesondere eines ASICs nebeneinander in einem vorgeformten Gehäuse mit elektrischen Anschlüssen, welche die Signale aus dem ASIC und der verkapselten Struktur außen zugänglich machen und diese mittels Drahtbonden kontaktieren, ist mit der Durchkontaktierungs -und Halbleiterelektrodentechnologie des Verkapselungsmoduls möglich. Als ein solches Gehäuse kann beispielsweise ein Cavity-Plastikgehäuse, ein Metallgehäuse oder ein MID-Package verwendet werden. Die Anbindung des Deckels (LID), beispielsweise eines Metalldeckels zur elektromagnetischen Schirmung, an das Gehäuse kann beispielsweise durch Kleben oder Laserschweißen erfolgen. Der freie Raum innerhalb des Gehäuses wird vorzugsweise mit Gel, insbesondere einem Silikon-Gel, zur Stabilisierung der Drähte und zum Abdichten der Bauteile gegen Feuchtigkeit aufgefüllt. Insbesondere wird unter die verkapselte Struktur eine Zwischenschicht, beispielsweise ein Plättchen mit hoher Masse, angeordnet, welche ein mechanisches Entkoppeln der verkapselten Struktur, beispielsweise bezüglich von Schwingungen bewirkt. Besonders bevorzugt wird die Zwischenschicht weich gegenüber bzw. mit dem Gehäuse und hart gegenüber bzw. mit der verkapselten Struktur befestigt.

Zur Erzeugung einer mikromechanischen Anordnung von verkapselten Strukturen inklusive Regelungs- und Signalauswerteschaltung (ASIC) wird alternativ vorzugsweise eine Assemblierung mittels Flip-Chip direkt auf den ASIC und anschließend in ein vorgeformtes Gehäuse durchgeführt. Die Assemblierung auf dem ASIC mittels Flip-Chip Technologie ist mittels des Verkapselungsmoduls mit Durchkontaktierungen und insbesondere mit diesen verbundenen Halbleiter-Leiterbahnen zur Kontaktierung, möglich. Zwischen ASIC und verkapselter Struktur kann sich beispielsweise ein Einbettungsmaterial (under-fill) zum mechanischen Fixieren, zur Schwingungsdämpfung und zum Schutz der elektrischen Kontakte, beispielsweise gegen Partikel, dem Vergussmaterial oder Feuchtigkeit befinden. Vorteil der Flip-Chip Technologie ist eine selbstjustierende Wirkung zu den Kontakten auf dem ASIC und damit der geometrischen Ausrichtung der verkapselten Struktur auf dem, bzw. zum ASIC und die Einsparung des Anklebens und Drahtbondens der verkapselten Struktur. Der daraus resultierende Chip-Stack bzw. die Kombination aus ASIC mit per Flip-Chip aufgesetzer verkapselter Struktur, kann wiederum mittels Flip-Chip Technologie direkt in ein vorgeformtes Gehäuse assembliert werden. Ein solches Gehäuse kann beispielsweise ein vorgeformtes Plastik-, Metall- oder Keramikgehäuse oder ein MID-Package sein. Die mechanische Befestigung und Abdichtung des Gehäuses zum ASIC erfolgt vorzugsweise durch Kleben oder Laserschweißen. Der freie Raum innerhalb des Gehäuses wird insbesondere mit Gel bzw. Silikon-Gel, zur Stabilisierung der Drähte und zum Abdichten der Bauteile gegen Feuchtigkeit, aufgefüllt.

Um mehrere verkapselte Strukturen und mindestens einen ASIC auf einem einfachen Siliziumwafer oder auf einem Verkapselungsmodul bzw. einem entsprechenden Verkapselungswafer mit Durchkontaktierungen und Verpacken zu einem komplexen Modul zusammen zu fügen, werden bevorzugt die verkapselten Strukturen zusammen mit anderen Bauteilen, wie beispielsweise mindestens einem ASIC, auf einem Siliziumwafer, welcher insbesondere als Träger fungiert, mittels Flip-Chip Technologie, Kleben, Löten oder Drahtbonden assembliert bzw. angeordnet. Diese Bauteile bilden so besonders bevorzugt ein Chip-Stack. Die elektrischen Verbindungen zwischen den Bauteilen werden auf dem Siliziumwafer mittels einfacher Metallisierung und Strukturierung zu Halbleiter-Leiterbahnen hergestellt. Die Metallisierung ist besonders bevorzugt durch Drahtbonden mit elektrischen Kontakten zu verbinden oder geeignet für Flip-Chip Prozesse. Ganz besonders bevorzugt wird ein Under-Fill Material verwendet. Mit dem gleichen oder einem ähnlichen Verfahren, wie die Herstellung von Halbleiter-Elektroden auf dem Verkapselungsmodul durchgeführt werden, werden bevorzugt auch Drahtlose Empfangs- und Sendestrukturen, wie beispielsweise Spulen oder Antennen gefertigt und auf dem gesamten System erzeugt. Ebenso könnten hierfür Oberflächenwellenfilter (OWF) und auch passive Komponenten zusätzlich auf dem Träger assembliert werden.

Vorzugsweise wird das ASIC oder der Verkapselungswafer bzw. der Durchkontaktierungswafers als Gehäuseabschluss, insbesondere Gehäuseboden verwendet. Dadurch wird ein angepasstes thermisches Ausdehnungsverhalten und somit ein geringer Einfluss des Package auf die verkapselte Struktur unter Temperaturbelastung erreicht.

Zur Verkapselung und/oder Verbindung von zwei oder mehr mikromechanischen Modulen werden bevorzugt Zwischenschichten aus einem Material mit hoher Dichte und insbesondere mit an Silizium angepassten Temperaturausdehnungskoeffizienten und/oder mit nahezu invariablem Temperatur-Ausdehnungsverhalten und/oder aus Kleberschichten mit unterschiedlichen Härte und/oder Metalle für eutektische Bondverbindungen und/oder Polymere zum Kleben verwendet. Hierdurch kann insbesondere eine zuverlässige und robuste Verbindung sowie eine mechanische Entkopplung erreicht werden.

Es ist zweckmäßig, dass die vorgeschlagene Verfahrensschritte zur Herstellung eines Verkapselungsmoduls oder einer mikromechanischen Anordnung ebenfalls zusätzlich die mikromechanische Anordnung oder das Verkapselungsmodul an sich betreffen und umgekehrt, das heißt bevorzugte Merkmale des Verkapselungsmoduls oder der mikromechanischen Anordnung betreffen zusätzlich ebenfalls alternative und/oder weiterführende bzw. ergänzende Verfahrensschritte.

Die Erfindung betrifft zusätzlich die Verwendung des Verkapselungsmoduls oder der mikromechanischen Anordnung in einem Kraftfahrzeug, insbesondere in einem Kraftfahrzeugregelungssystem.

Das erfindungsgemäße Verkapselungsmodul oder die erfindungsgemäße mikromechanische Anordnung sind bevorzugt für eine Verwendung in Kraftfahrzeugen, insbesondere für eine Verwendung in Kraftfahrzeugregelungssystemen, besonders bevorzugt in einem Kraftfahrzeugbremssystem, vorgesehen. Für die Integration verschiedener Applikationen, wie Druck-, Beschleunigungs- oder Drehratensensoren, werden häufig verschiedene Verpackungstechnologien benötigt, um deren spezifischen Anforderungen gerecht zu werden. Das erfindungsgemäße Verkapselungsmodul ist ganz besonders bevorzugt zur Verpackung und Integration solch unterschiedlicher Sensorelemente, insbesondere auf einem gemeinsamen Chip, vorgesehen.

Weitere bevorzugte Ausführungsformen ergeben sich aus den Unteransprüchen und den nachfolgenden Beschreibungen von Ausführungsbeispielen an Hand von Figuren.

Die folgenden Figuren bieten eine schematische Darstellung von Ausführungsbeispielen. Diese Ausführungsbeispiele können sowohl als Anordnungen, als auch als veranschaulichte Verfahrensstände einer Anordnung, bzw. eine jeweilige Anordnung zu einem definierten Verfahrenszeitpunkt des entsprechenden Herstellungsverfahrens, verstanden werden.

Es zeigen dabei in schematischer Darstellung
- Fig. 1 bis 6: ein Ausführungsbeispiel eines Verkapselungsmoduls mit Durchkontaktierungen und Halbleiter-Elektroden, wobei einzelne Herstellungszustände veranschaulicht sind,
- Fig. 7 bis 10: Ausführungsbeispiele für Strukturmodule,
- Fig. 11 bis 13: beispielhafte Verkapselungsmodule sowie Herstellungsstadien von beispielgemäßen Verkapselungsmodulen,
- Fig. 14 bis 16: beispielgemäße Herstellungsstadien eines Verkapselungsmoduls bzw. alternative Verkapselungsmodule, insbesondere umfassend einen Tunnel,
- Fig. 17 bis 20: beispielhafte Ausführungsformen mikromechanischer Anordnungen umfassend ein Verkapselungsmodul, welches ein oder zwei Strukturmodule, insbesondere hermetisch, verkapselt,
- Fig. 21, 22: beispielhafte elektrische Kontaktierungen eines mit einem Verkapselungsmodul verkapselten Strukturmoduls,
- Fig. 23, 24: den selektiven Einschluss unterschiedlicher Medien innerhalb unterschiedlicher Strukturräume eines mit einem Verkapselungsmodul verkapselten Strukturmoduls,
- Fig. 25, 26: zwei beispielhafte mikromechanische Anordnungen,
- Fig. 27 bis 29: Ausführungsbeispiele mikromechanischer Anordnungen in einem zusätzlichen Gehäuse, und
- Fig. 30 bis 36: verschiedene beispielhafte mikromechanische Anordnungen und Systeme, welche mikromechanische Module umfassen.

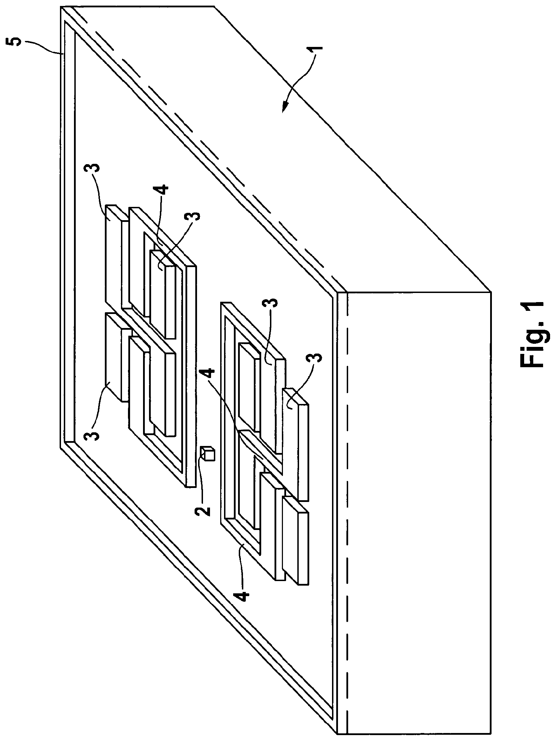

Fig. 1 zeigt einen beispielhaften Wafer bzw. Rohkörper 1 aus elektrisch leitfähigem Halbleitermaterial, in diesem Fall dotiertes Silizium, aus welchem mittels eines Ätzverfahrens Halbleitermaterial entfernt wird, wodurch elektronische Anschlussmittel ausgebildet werden. Hierbei wird ausgehend von der Deckfläche des Wafers 1 im Wesentlichen senkrecht nach unten geätzt. Auf dem Wafer sind beispielgemäß Halbleiter-Elektroden 3, Halbleiter-Leiterbahnen 4, welche elektrische Verbindungen zwischen Halbleiter-Elektroden herstellen, sowie ein Ansatz einer Durchkontaktierung 2 ohne zugeordnete Halbleiter-Elektrode oder Halbleiter-Leiterbahn als elektronische Anschlussmittel ausgebildet. Des Weiteren weist Wafer 1 einen Rahmen 5 auf. Solch ein Rahmen ist in einem nicht dargestellten, alternativen Ausführungsbeispiel nicht vorhanden. Halbleiter-Elektroden 3 sind beispielhaft im Wesentlichen inselförmig ausgebildet.

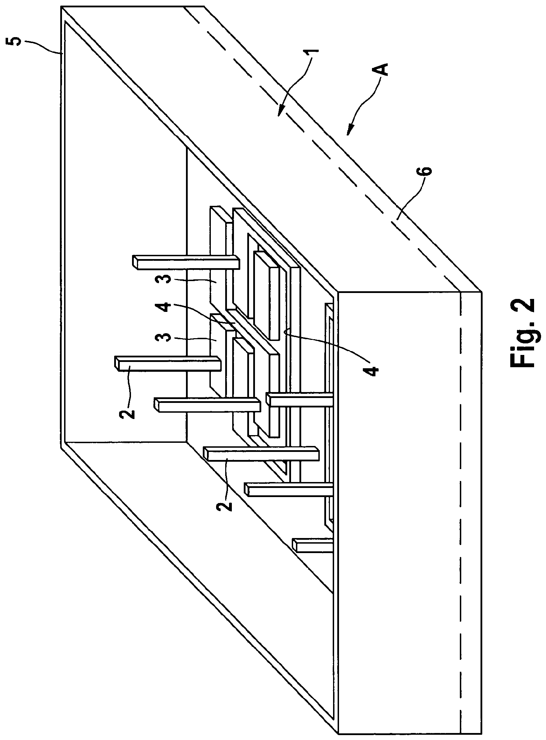

In Fig. 2 ist das dotierte Silizium des Wafers bzw. Rohkörpers 1 beispielgemäß zum großen Teil weiter heruntergeätzt, so dass ein relativ flacher Sockel 6 des Halbleitermaterials ausgebildet ist, auf welchem die elektronischen Anschlussmittel in Form von Halbleiter-Elektroden 3, Halbleiter-Leiterbahnen 4 und Durchkontaktierung 2 angeordnet sind. Dabei sind die Durchkontaktierungen 2 säulenförmig ausgebildet und meistenteils auf jeweils einer Halbleiter-Elektrode 3 angeordnet. Diese jeweilige Durchkontaktierung ist dabei mit der jeweiligen Halbleiter-Elektrode 3 einstückig verbunden. Beispielgemäß weist Verkapselungsmodul A in dem veranschaulichten Stadium des Herstellungsprozesses einen Rahmen 5 aus elektrisch leitendem Halbleitermaterial 5 auf. In einem nicht dargestellten, alternativen Ausführungsbeispiel ist dieser Rahmen 5 nicht vorhanden bzw. wurde im Zuge der Ätzprozesse bis auf den Sockel 6 herunter entfernt.

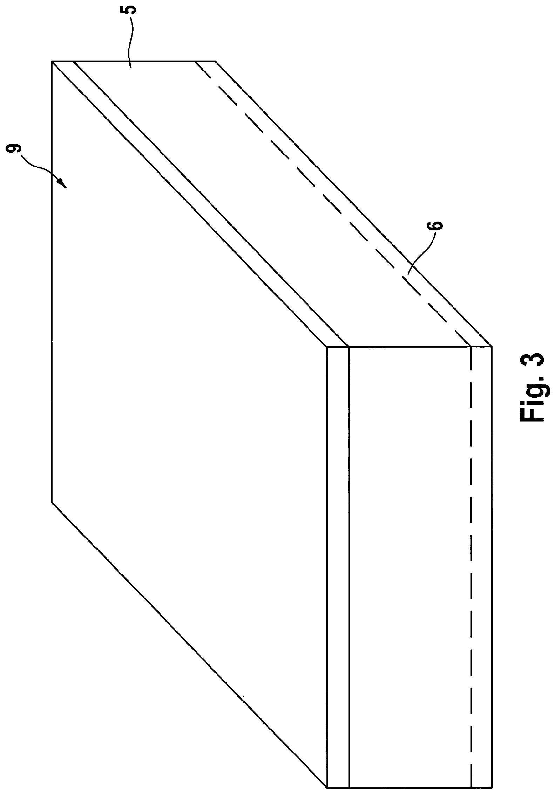

Fig. 3 veranschaulicht beispielhaft die Einbettung der aus dotiertem Halbleitermaterial erzeugten elektronischen Anschlussmittel mit einem elektrischen isolierenden Einbettungsmaterial 9, beispielgemäß ein Glasmaterial. Erkennbar sind dabei außerdem der Sockel des Halbleitermaterials 6, auf welchem die elektronischen Anschlussmittel angeordnet sind, sowie der Rahmen 5, welcher zur Aufnahme des Einbettungsmaterials 9 dient, da dieses in flüssigem Zustand die elektronischen Anschlussmittel einbettet und anschließend aushärtet. Rahmen 5 kann auch im Wesentlichen den gesamten Verkapselungsmodul-Wafer umfassen bzw. umschließen und somit als Fließgrenze dienen. Rahmen 5 dient außerdem optional der mechanischen Stabilisierung des Wafers nachdem die Durchkontaktierungen ausgebildet sind.

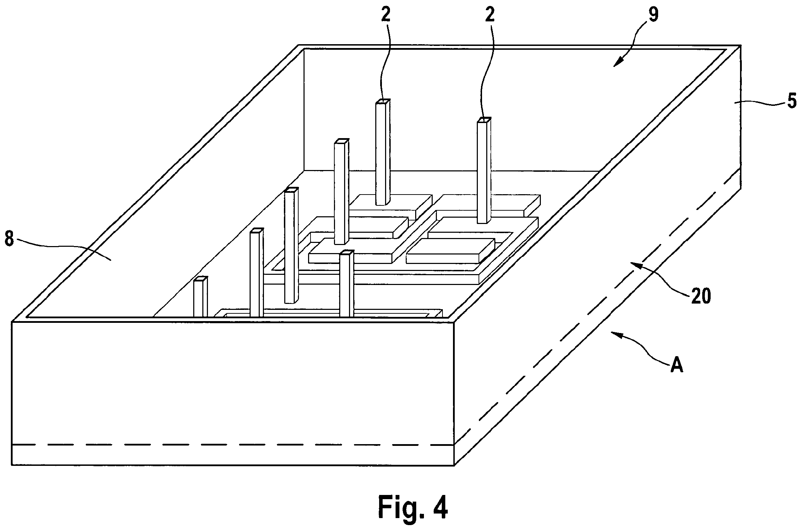

In Fig. 4 ist ein weitergebildetes Beispiel eines noch unfertigen Verkapselungsmoduls A dargestellt, bei welchem Einbettungsmaterial 9 soweit zurückgebildet bzw. zurückgedünnt wurde, dass Durchkontaktierungen 2 eine gemeinsame, kontaktierbare Fläche mit Deckfläche 8 aufweisen. Einbettungsmaterial 9 sowie Rahmen 5 bilden einen, im Wesentlichen scheibenförmigen Körper 20 aus.

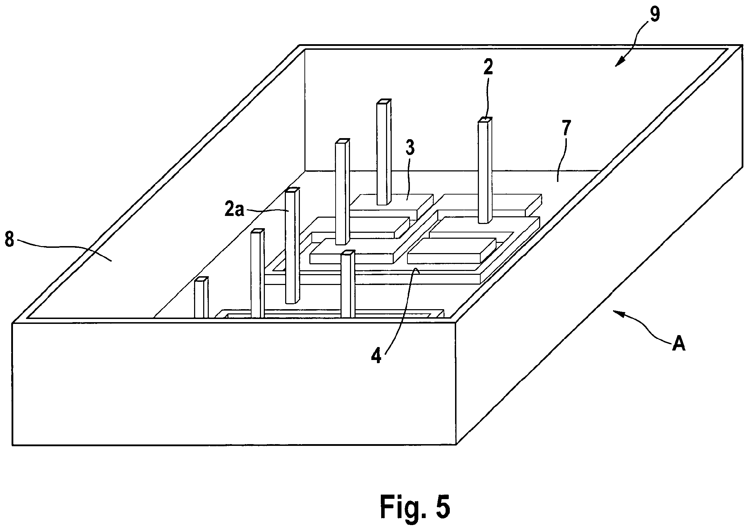

Fig. 5 zeigt ein Ausführungsbeispiel eines Verkapselungsmoduls A dessen Sockel des Halbleitermaterials, auf welchem die elektronischen Kontaktelemente angeordnet waren, entfernt wurde und die Halbleiter-Elektroden 3 sowie die Leiterbahnen 4 und Durchkontaktierung 2a eine gemeinsame, elektrisch kontaktierbare Fläche mit der Grundfläche 7 bzw. unteren Außenfläche des Verkapselungsmoduls A aufweisen. Hinsichtlich der Deckfläche 8 bzw. oberen Außenfläche weisen Durchkontaktierungen 2 jeweils eine gemeinsame Kontaktierfläche auf. Die gemeinsamen Flächen der elektronischen Anschlussmittel mit der Grund- 7 und der Deckfläche 8 sind bündig mit diesen Flächen 7, 8 ausgebildet.

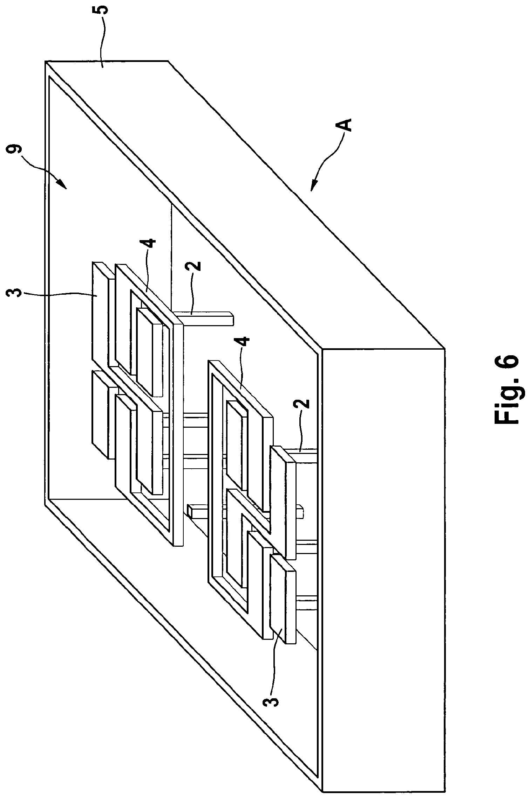

In Fig. 6 ist ein Ausführungsbeispiel eines Verkapselungsmoduls A veranschaulicht, bei welchem die gemeinsamen, bündig abschließenden Flächen der Halbleiter-Elektronen 3 und Halbleiter-Leiterbahnen 4 mit der einen Basisfläche des Verkapselungsmoduls A sichtbar sind. Diese elektronischen Anschlussmittel, wozu ebenfalls Durchkontaktierungen 2 zählen, sind in Einbettungsmaterial 9, welches beispielgemäß Glas ist, eingebettet. Aus dotiertem Silizium bestehender Rahmen 5, welcher in einem nicht dargestellten Ausführungsbeispiel fehlt, dient beispielhaft zur elektromagnetischen Abschirmung. Rahmen 5 dient optional, hinsichtlich der Rahmen mehrerer beispielgemäßer Verkapselungsmodule auf einem Wafer, auch als Sägestraße bzw. Sägespur, da Silizium leichter zu sägen ist als Glas. Zusätzlich dient Rahmen 5 optional auch der mechanischen Stabilisierung.

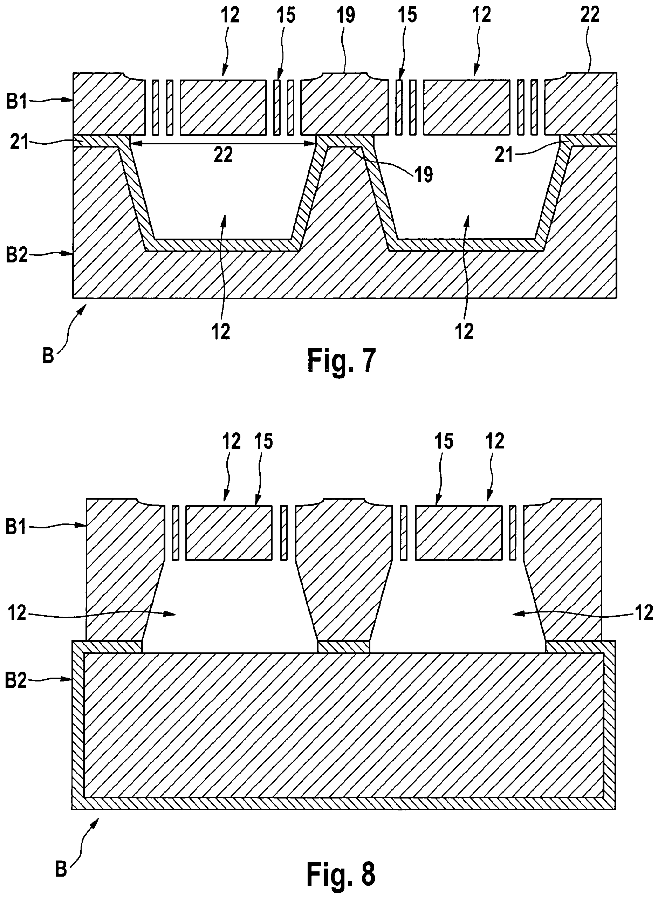

Fig. 7 zeigt ein Ausführungsbeispiel eines mikromechanischen Strukturmoduls B bzw. eines Strukturwafers, welcher durch beispielgemäß anisotropes Siliziumätzen erzeugte Strukturen 15 aufweist. Strukturmodul B besteht dabei aus einem Strukturwafer B1 und einem mit diesem verbundenen Trägerwafer B2. Trägerwafer B2 weist beispielgemäß zwei Kavitäten 12 auf, welche mechanische Auslenkungen der Strukturen 15 ermöglichen, sowie Ankerpunkt 19 und Rahmen 21, an denen Trägerwafer B2 mit Strukturwafer B1 mittels eines Fügeverfahrens fest verbunden sind. Zum einen kann die Fügefläche 22 gänzlich von einer Kavität 12 umgeben sein, was einen Ankerpunkt 19 innerhalb der Membran erzeugt, zum anderen kann die Kavität 12 gänzlich von einer Fügefläche 22 umgeben sein, was einen geschlossenen Rahmen 21 erzeugt. Ein oder mehrere Ankerpunkte können sich auch innerhalb eines geschlossenen Rahmens befinden. Strukturwafer B1 weist an seiner oberen Außenfläche zusätzliche, eigene Kavitäten 12, Ankerpunkt 19 sowie Rahmen 22 auf. Hierdurch kann beispielhaftes Strukturmodul B mit einem Verkapselungsmodul verkapselt werden, wobei das Verkapselungsmodul dann keine Kavitäten zum Auslenken der Strukturen 15 benötigt. Ankerpunkt 19 sowie Rahmen 22 auf der oberen Fläche des Strukturmoduls bilden dabei die Fügeflächen zur Verbindung mit einem Verkapselungsmodul.

Fig. 8 veranschaulicht eine beispielhafte Alternative zu oben beschriebenem Strukturmodul B. Dieses Strukturmodul B wird beispielgemäß hergestellt, indem ein vorgefertigter Strukturwafer B1 auf einen, beispielhaft unstrukturierten und mit einer oxidierten Schicht oberzogenen, Trägerwafer B2 aufgebracht wird. Strukturwafer B1 weist dabei oberhalb und unterhalb jeder Struktur 15 Kavitäten 12 zur Auslenkung der Strukturen 15 auf.

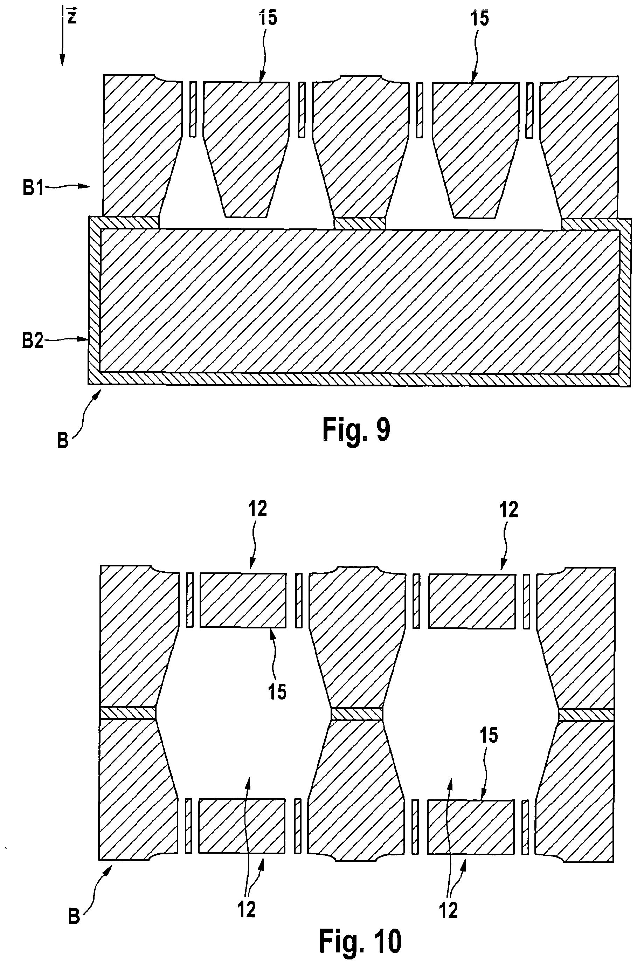

Fig. 9 zeigt ein Ausführungsbeispiel eines Strukturmoduls B, welches einen Strukturwafer B1 und einen Trägerwafer B2 umfasst, wobei Strukturwafer B1 Strukturen 15 mit ausgelagerten Masseschwerpunkten aufweist. Die Massenschwerpunkte der Strukturen bzw. der seismischen Massen sind dabei in z-Richtung außerhalb der durch den Rahmen der Struktur aufgespannten Ebene ausgelagert. Die seismischen Massen der Strukturen 15 sind beispielgemäß entsprechend in z-Richtung ballig ausgebildet.

Fig. 10 zeigt hingegen ein beispielhaftes Strukturmodul B mit Strukturen 15 in beiden Seiten der Membran. Dabei lassen sich die Größen der Kavitäten 12 durch einen beispielhaft anisotropen Ätzprozess wunschgemäß ausbilden. Strukturmodul B besteht dabei beispielgemäß aus zwei über Rahmen und Ankerpunkte aneinandergefügte Strukturwafer.

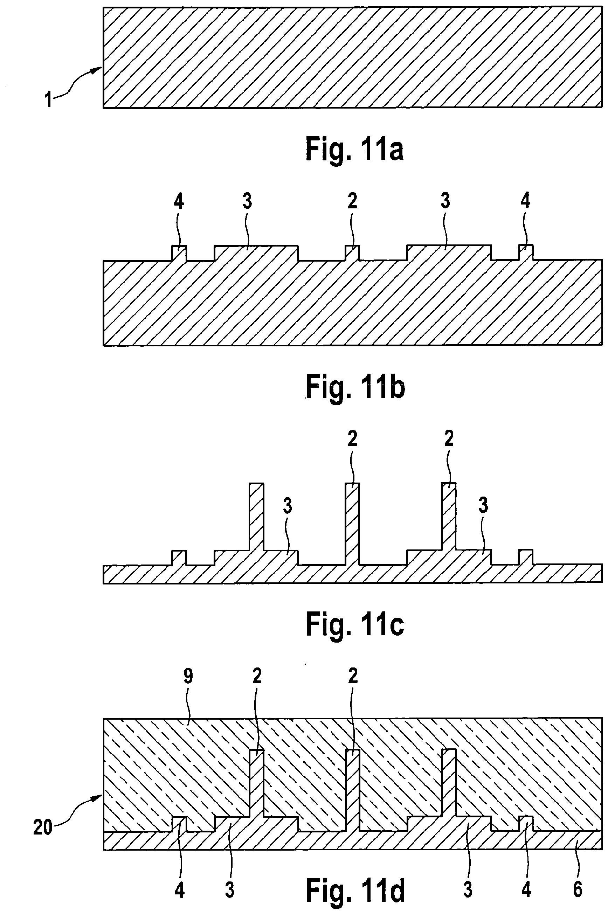

Fig. 11, Fig. 12 und Fig. 13 veranschaulichen anhand verschiedener, dargestellter Schritte ein beispielhaftes Verfahren zur Herstellung eines Verkapselungsmoduls, inklusive unterschiedlicher Varianten. Dabei zeigt Fig. 11 a) das Basismaterial bzw. den Rohkörper 1 in Form eines hoch dotierten und damit leitfähigen Siliziumwafers. In den Fig. 11 b) und c) werden beispielgemäße Schritte der anisotropen Ätzvorgänge zur Erzeugung der späteren Halbleiter-Elektroden 3, der Durchkontaktierung 2 und Halbleiter-Leiterbahnen 4 dargestellt. Dabei bleibt während des Ätzvorgangs die jeweilige Halbleiter-Elektrodengeometrie von Fig. 11 b) zu Fig. 11 c) erhalten. In Fig. 11 d) sind die beispielgemäßen elektronischen Anschlussmittel, wie die Durchkontaktierungen 2, die Halbleiter-Leiterbahnen 4 und die Halbleiter-Elektroden 3 mit einem elektrisch isolierenden Einbettungsmaterial 9, beispielsweise vergossenes Glas mit einem silizium-ähnlichen thermischen Ausdehnungsverhalten, eingebettet. Dieses wird anschließend ausgehärtet, wobei die Verbindungen des Materials zu den elektronischen Anschlussmitteln und dem Restblock bzw. Sockel 6 aus Silizium mechanisch stabil werden. Einbettungsmaterial 9 ist dabei als ein im Wesentlichen scheibenförmiger Körper 20 ausgebildet.

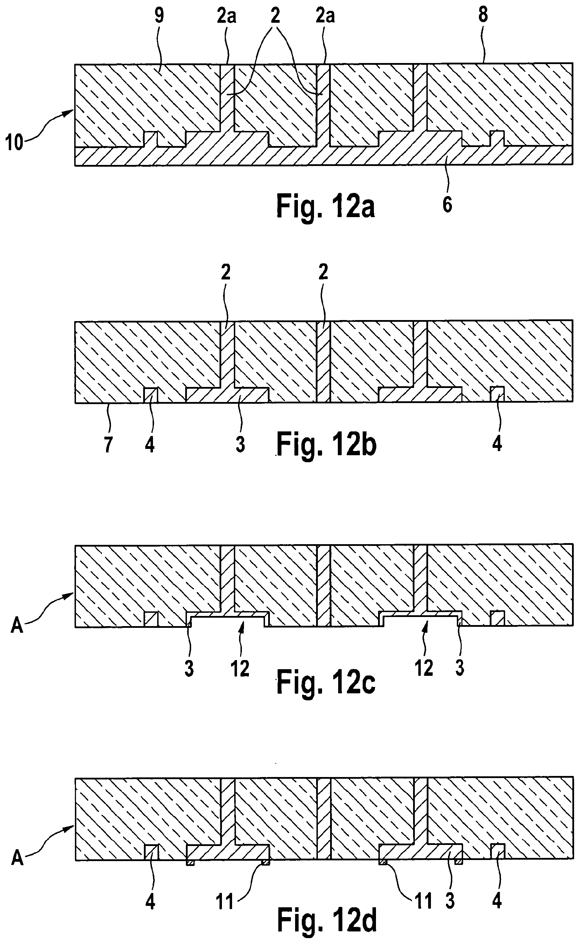

In Fig. 12 a) ist das Einbettungsmaterial 9 an der oberen Fläche beispielsweise soweit abgeschliffen und diese Fläche so poliert, dass die Durchkontaktierungen 2 jeweils eine entsprechend freiliegende, mit der oberen Fläche bzw. Deckfläche 8 des scheibenförmigen Körpers 10 bündig abschließende Fläche 2a aufweisen. Fig. 12b) zeigt einen entsprechend zurückgeschliffenen Sockel 6 des Siliziumwafers, so dass die Durchkontaktierung 2, die Halbleiter-Leiterbahnen 4 und die Halbleiter-Elektroden 3 auch an dieser unteren Fläche, der Grundfläche 7, jeweils eine freiliegende, bündige Fläche aufweisen. Diese elektronischen Anschlussmittel sind dabei hinsichtlich ihrer seitlichen Kontaktflächen elektrisch isoliert im Vergussmaterial eingebettet. In das in Fig. 12 c) beispielhaft dargestellt Verkapselungsmodul sind zusätzliche Kavitäten 12 in die Halbleiter-Elektroden 3 eingebracht. Dies kann beispielsweise durch einen Ätzprozess erreicht werden. Diese Kavitäten 12 dienen beispielgemäß jeweils der Auslenkungsfreiheit einer Struktur, welche mittels des beispielgemäßen Verkapselungsmoduls A verkapselt werden kann. Fig. 12 d) zeigt ein Ausführungsbeispiel eines Verkapselungsmoduls A, welches beispielhaft zusätzlich aufgebrachte Stopper bzw. Pufferelemente 11 aufweist, die durch Aufbringen und Strukturieren von Siliziumoxid hergestellt werden. Diese Pufferelemente 11 sind beispielgemäß auf Halbleiter-Elektroden 3 aufgebracht. Zusätzlich weist Verkapselungsmodul A auch in dieser Ausführungsform zusätzliche Halbleiter-Leiterbahnen 4 aus hochdotiertem Silizium auf. Diese können beispielgemäß mit Elektroden und Durchkontaktierungen verbunden sein.

In einem nicht dargestellten Ausführungsbeispiel des Verkapselungsmoduls aus Fig. 12 c) sind einige Halbleiter-Elektroden vollständig entfernt zur Bereitstellung größerer Kavitäten. Dabei werden beispielgemäß Halbleiter-Elektroden verwendet, welche nicht mit einer Durchkontaktierung verbunden sind, sondern einzeln bzw. separat ausgebildet sind. Durch das Entfernen solcher Halbleiter-Elektroden lassen sich in relativ einfacher Weise Kavitäten in dem Einbettungsmaterial wie Glas oder Polymere herstellen.

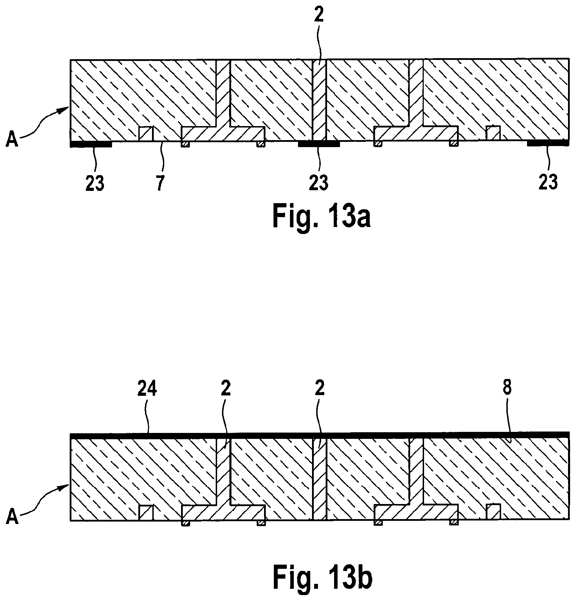

Für bestimmte Applikationen ist die Anordnung von in Fig. 13 a) gezeigten bespielgemäßen Metallschichten 23 als eutektische Bondrahmen auf am Rand der Grundfläche 7 eines Ausführungsbeispiels eines Verkapselungsmoduls A vorteilhaft. Außerdem ist Durchkontaktierung 2 beispielhaft mittels einer Metallschicht 23 kontaktierbar. In Fig. 13 b) weist das beispielhafte Verkapselungsmodul A an dessen oberer Außenfläche bzw. Deckfläche 8 eine leitfähige Schicht 24, insbesondere aus Metall, auf. Hierdurch werden die Durchkontaktierungen 2 elektrisch leitend verbunden.

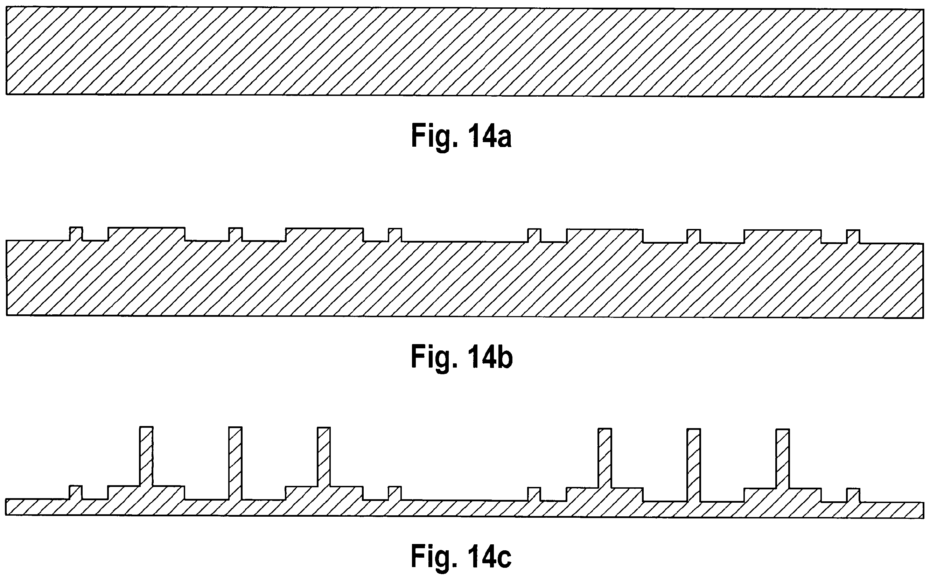

In den Fig. 14, 15 und 16 ist ein weiteres beispielhaftes Verfahren zur Herstellung eines Verkapselungsmoduls anhand beispielgemäß dargestellter Schritte bzw. Fertigungsstadien veranschaulicht. Dabei sind einige der Fertigungsstadien ebenfalls als alternative Ausführungsbeispiele eines Verkapselungsmoduls zu verstehen.

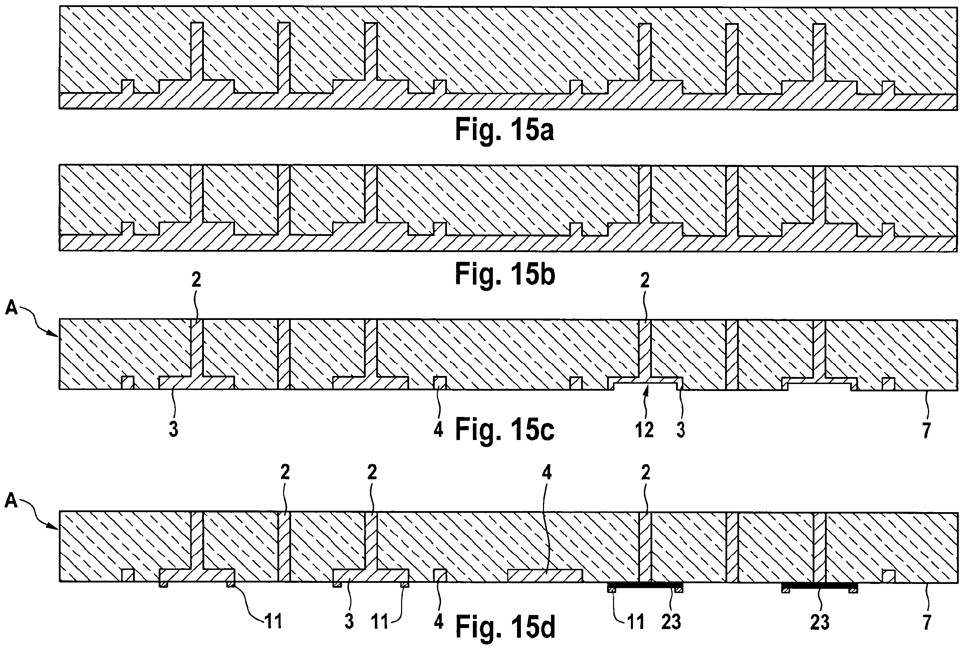

Es zeigen Fig. 14 und Fig. 15 Herstellungsstadien eines Verkapselungsmoduls mit Elektrodenkonfiguration bzw. mit Halbleiterelektroden. Dabei zeigt Verkapselungsmodul A in Fig. 15 c) zwei Halbleiter-Elektroden 3 mit jeweils einer Kavität 12 und zwei Halbleiter-Elektroden 3 ohne Kavität. Halbleiterelektroden 3 sind jeweils mit einer Durchkontaktierung 2 verbunden. Außerdem weist Verkapselungsmodul A Halbleiter-Leiterbahnen 4 auf. Diese Halbleiter-Leiterbahnen 4 sind ebenfalls zur elektrischen Kontaktierung von der Grundfläche 7 her geeignet. Fig. 15 d) stellt ein alternativ beispielhaftes Verkapselungsmodul A dar, welches bezüglich der Grundfläche 7 jeweils auf Durchkontaktierungen 2 aufgebrachte Metallschichten 23 und auf zwei Halbleiter-Elektroden 3 sowie den Metallschichten bzw. -elektroden 23 aufgebrachte Stopper bzw. Pufferelemente 11 aus elektrisch nichtleitendem Material aufweist. Darüber hinaus weist Verkapselungsmodul A Halbleiter-Leiterbahnen 4 auf.

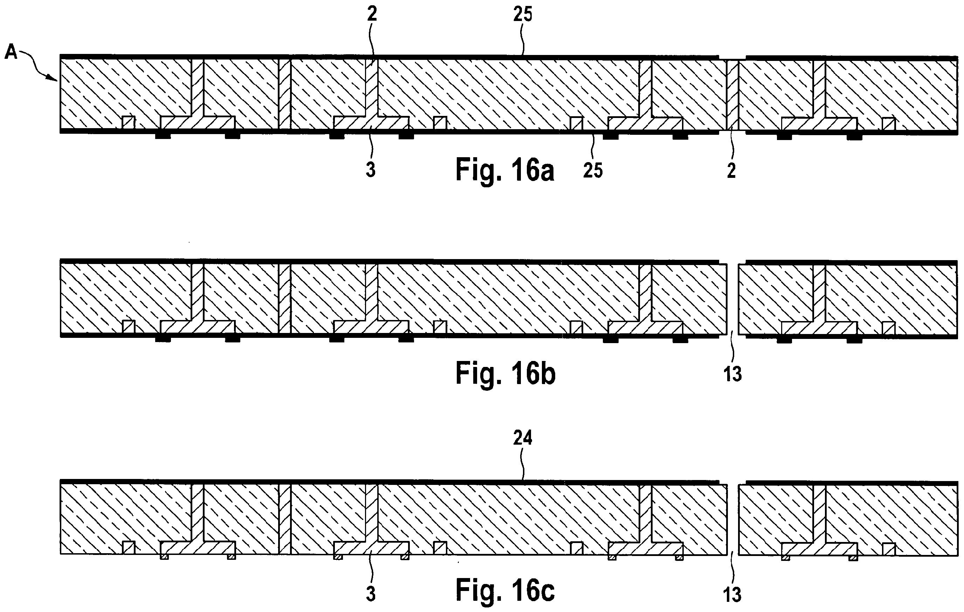

In Fig. 16 a) ist eine Passivierungsschicht 25 auf beispielhaftes Verkapselungsmodul A beidseitig aufgebracht. Diese ist an gewünschter Stelle geöffnet. Die Passivierungsschicht verhindert das Entfernen oder Beschädigen elektronischer Anschlussmittel, wie Halbleiter-Elektroden 3 oder Durchkontaktierungen 2 im Zuge eines anschließenden Ätz-Prozesses zur Erzeugung eines Tunnels durch die Basisflächen des Verkapselungsmoduls. Fig. 16 b) zeigt eine Durchlassöffnung durch das Verkapselungsmodul aus Fig. 16 a), welche durch das Entfernen einer Durchkontaktierung erzeugt wurde. Dieses Entfernen wird beispielgemäß mittels eines Ätzprozesses durchgeführt. Die Durchlassöffnung bzw. der offene Tunnel 13 ermöglicht einen Medienaustausch und/oder ein definiertes Einstellen eines Mediums, wie beispielsweise eines Gases oder einer Flüssigkeit, durch das Verkapselungsmodul hindurch. Anschließend wird die Passivierungsschicht wieder entfernt. In Fig. 16 c) ist nach dem erfolgten Entfernen der Passivierungsschicht beispielhaft eine Kontaktierungsmetallisierung 24 auf der Deckfläche 7 bzw. der den Halbleiter-Elektroden 3 gegenüberliegenden Basisfläche aufgebracht.

Geöffneter Tunnel 13 ist in einem nicht dargestellten, alternativen Ausführungsbeispiel mittels eines Glasmaterials, nach Einbringen einer definierten Atmosphäre in einen Strukturraum durch den geöffneten Tunnel 13, wieder verschlossen.

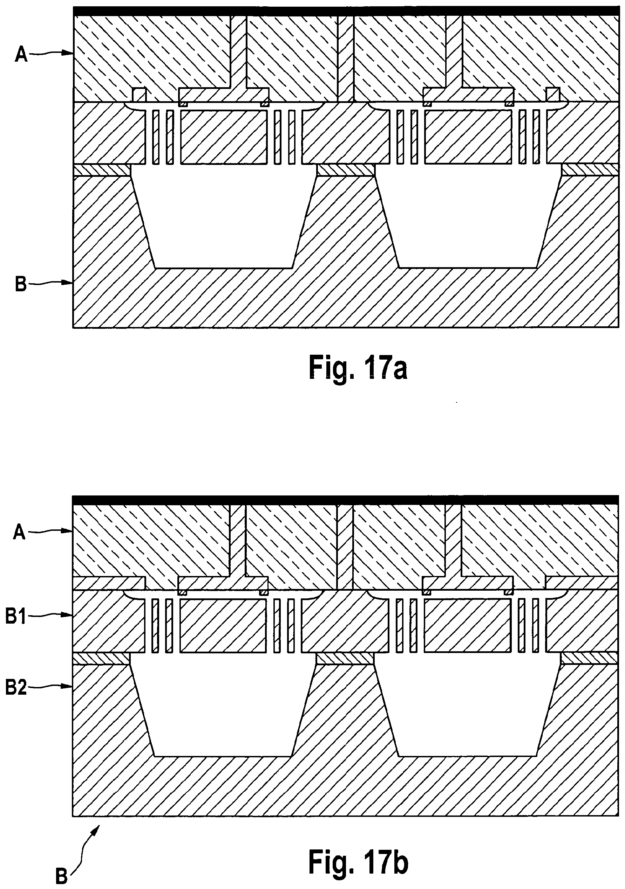

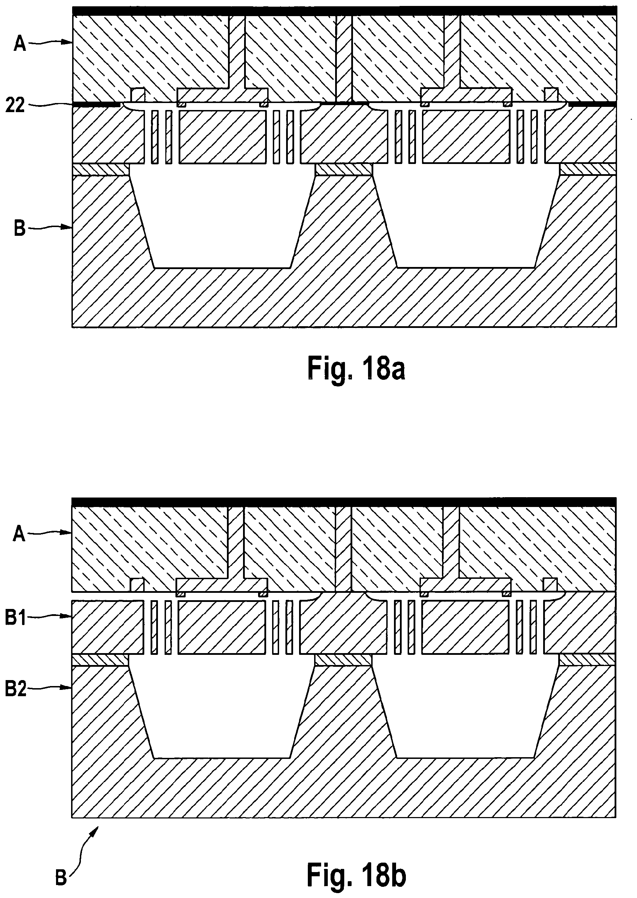

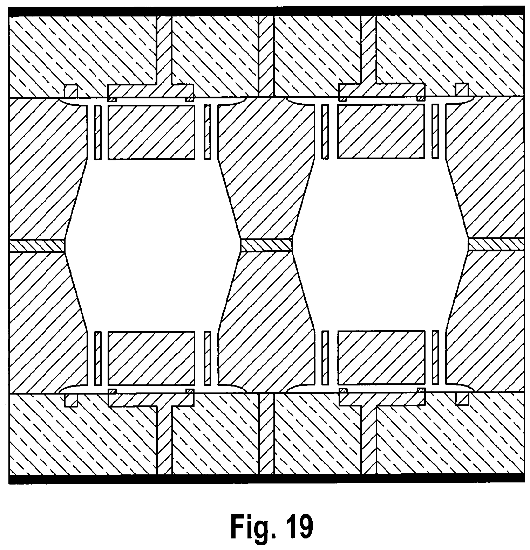

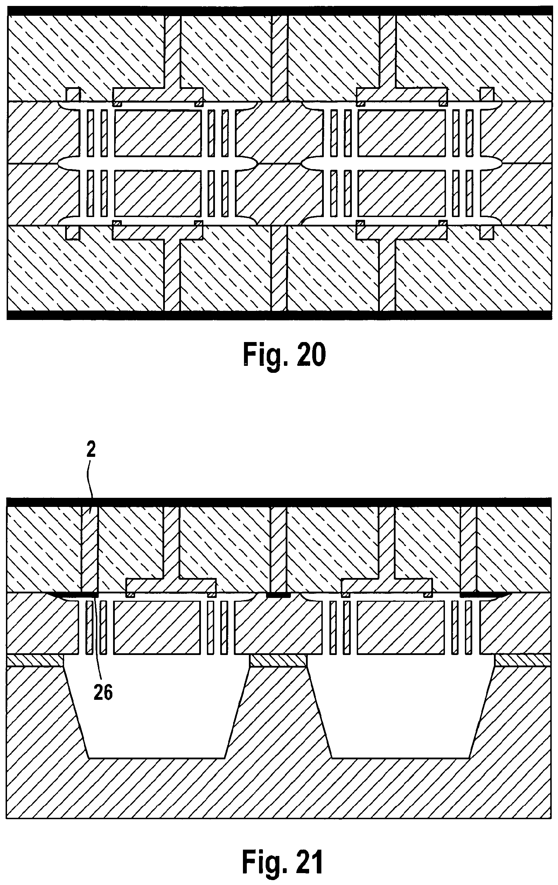

Fig. 17, 18, 19 und 20 veranschaulichen beispielhafte Ausführungsformen mikromechanischer Anordnungen umfassend ein Verkapselungsmodul A, welches ein oder zwei Strukturmodule B, insbesondere hermetisch bzw. gasdicht, verkapselt. Dabei ist in den Fig. 17 und 18 jeweils ein Verkapselungsmodul A auf Strukturmodul B angeordnet. Dieses Strukturmodul B umfasst dabei jeweils einen Strukturwafer B1 und einen Trägerwafer B2, welche mittels eines Fügeverfahrens miteinander verbunden sind. Die entsprechende Fügefläche 22 zwischen Verkapselungsmodul A und Strukturmodul B erstreckt sich über den Rahmen rechts und links, sowie die Ankerfläche des jeweiligen Strukturwafers. Im Bereich der jeweiligen Strukturen ist gegenüber den beiden Kavitäten des Strukturmoduls ein gewisser Spaltabstand zum Verkapselungsmodul vorhanden, welcher Auslenkungen der Struktur ermöglicht. Fig. 17 a) veranschaulicht den Fall, dass anodisch bondfähiges Glas als Vergussmaterial eingesetzt wird, wodurch das besonders robuste, anodische Bondverfahren zur hermetischen bzw. gasdichten Verkapselung des Strukturmoduls mit dem Verkapselungsmodul verwendet werden kann. Wie in Fig. 17 b) dargestellt, sollten in diesem Fall und im Fall, dass im Innenraum ein Vakuum eingestellt werden soll, die Glasflächen im Innenraum des Strukturmoduls mit Getter-Material beschichtet werden, da Glas für seine Ausgasungen bekannt ist. Im Ausführungsbeispiel aus Fig. 18 a) wird beispielhaft Au-Si bzw. Al-Ge oder andere eutektische Metallverbindungen als Fügemittel 22 zwischen Verkapselungsmodul A und Strukturmodul B verwendet, wodurch automatische eine elektrisch leitende Verbindung hergestellt wird und im Fall des eutektischen Bondens beispielhaft zum Einsatz kommt. In Fig. 18 b) wird beispielhaft eine Ausführungsform dargestellt, in welcher sich der Spalt zwischen den Modulen über den Bondrahmen erstreckt und so eine seitliche Öffnung vorhanden ist, durch welche ein Medienaustausch zwischen Außenraum und Strukturraum erfolgen kann. Fig. 19 und 20 stellen jeweils beispielhaft eine Verkapselung auf Ober- und Unterseite eines Strukturmodulpaares und damit eine Verkapselung auf beiden Seiten mittels eines Verkapselungsmoduls dar. Hierdurch lassen sich Sensoren unterschiedlicher Mess-Orientierung, insbesondere in unterschiedlicher Orientierung auslenkbare seismische Massen eines Sensorelements, verwirklichen, ohne dass die dazu benötigte Fläche größer wird. Die Strukturmodule sind dabei beispielhaft mittels Bonding miteinander verbunden.

In Fig. 21 ist beispielhaft abgebildet, wie eine elektrisch leitende Kontaktierung beispielgemäß umfassend eine Durchkontaktierung 2 von Verkapselungsmodul zu Strukturmodul mittels eines zusätzlichen metallischen Druckkontaktes bzw. Quetschkontaktes 26 durchgeführt werden kann. Bei Anker-Kontakten ist der Quetsch-Kontakt beispielhaft von der Fügefläche umgeben.

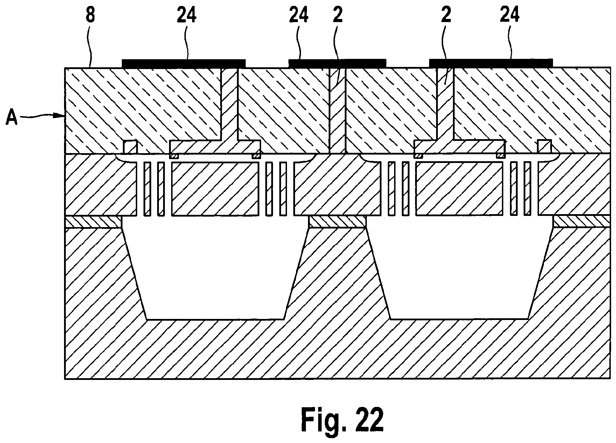

Fig. 22 zeigt beispielhaft eine strukturierte Kontaktmetallisierung 24 auf der oberen Außenfläche bzw. Deckfläche 8 des Verkapselungsmoduls A. Solch eine Strukturierung findet im Rahmen eines Herstellungsverfahrens beispielhaft anschließend zu den vorgehenden Schritten statt. Kontaktmetallisierungen 24 dienen zur externen elektrischen Kontaktierung der Durchkontaktierungen 2.

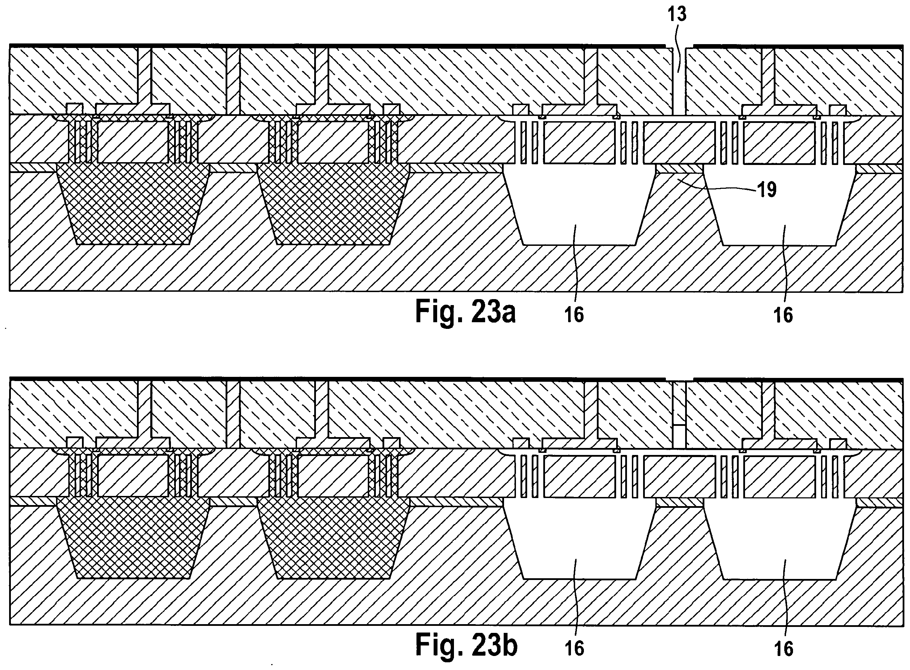

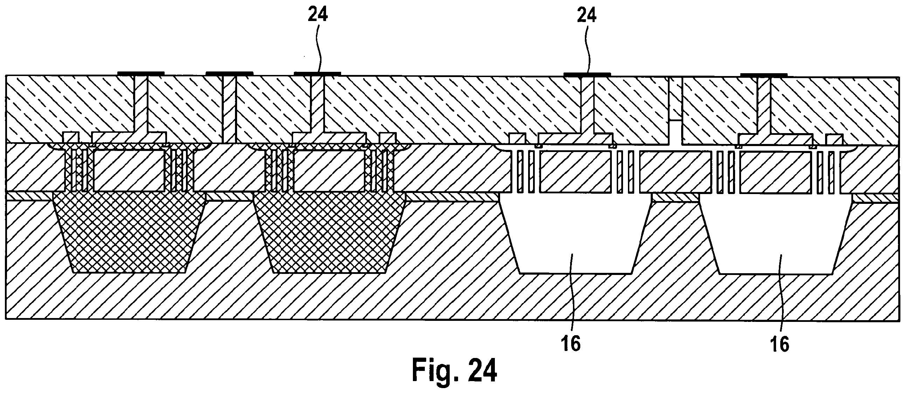

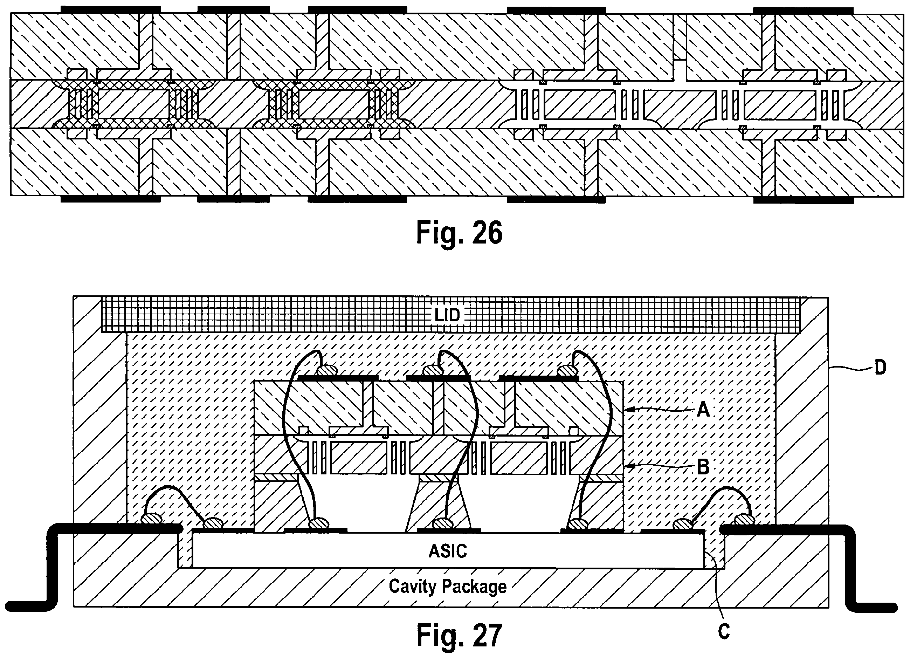

In Fig. 23 und 24 ist der selektive Einschluss unterschiedlicher Medien innerhalb unterschiedlicher Strukturräume 16 eines mit einem Verkapselungsmodul verkapselten Strukturmoduls beispielhaft veranschaulicht. Diese Strukturräume 16 umfassen die Kavitäten unter- und oberhalb der Strukturen des Strukturwafers. In diesem Zusammenhang zeigt Fig. 23 a) ein Ausführungsbeispiel in welchem sich der Spaltabstand zwischen Struktur- und Verkapselungsmodul, in Flucht mit einem Tunnel 13 zur oberen Außenfläche des Verkapselungsmoduls, über dem Ankerpunkt 19 erstreckt. Durch diesen offenen Tunnel 13, kann das eingeschlossene Medium aus dem Strukturinnenraum 16 beispielgemäß entweichen oder ein anderes, definiertes Medium alternativ in diesen eingebracht werden. Beispielweise kann die Verkapselung durch das Verkapselungsmodul unter Vakuum stattfinden, wodurch die Strukturinnenräume der linken Strukturen, welche durch gekreuzte Schraffur gekennzeichnet sind, ein Vakuum aufweisen, um beispielsweise sehr hohe Güten bei Drehratensensorelemente zu erzielen. Strukturinnenräume 16, auf der anderen Seite angeordnet, welche über geöffneten Tunnel 13 zugänglich sind, befüllen sich nach dem Belüften der Bondkammer mit Umgebungsatmosphäre. Alternativ beispielhaft können Ein- bzw. Auslässe für Drucksensoren, Flüssigkeitskanäle, Pumpen oder Ventile in dieser Form erzeugt werden. In Fig. 23 b) wird beispielhaft bei Bedarf, insbesondere anschließend an den beispielhaft in Fig. 26a) dargestellten Zustand, der offene Strukturinnenraum 16 erneut evakuiert und mit dem gewünschten Medium befüllt, welches für die jeweilige Applikation notwendig ist. Beispielgemäß wird in diesem Zusammenhang auch der entsprechende, gewünschte Druck eingestellt. Beispielsweise kann ein Ag-Gas-Überdruck eingestellt werden, um einen Beschleunigungssensor überkritisch zu dämpfen. Nach erfolgtem Medienaustausch, bzw. erfolgter Einstellung des Mediums, inklusive des gewünschten Drucks, wird die Öffnung vakuumdicht versiegelt. Dazu wird beispielhaft ein Vergussmaterial, wie flüssiges Glas in die Öffnung eingebracht und anschließend ausgehärtet. Wie in Fig. 24 beispielhaft veranschaulicht wird anschließend die Kontaktmetallisierung 24 strukturiert.

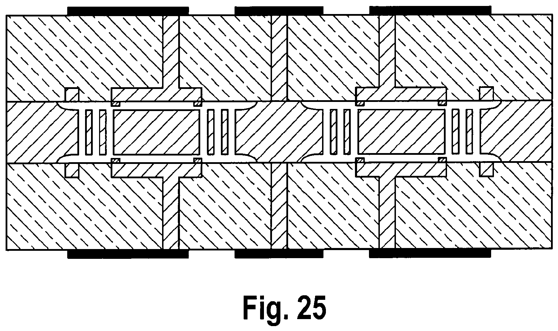

In den Fig. 25 und 26 ist die hermetische, beidseitige Verkapselung eines Strukturmoduls mit zwei Verkapselungsmodulen, beispielhaft veranschaulicht. Dabei zeigt Fig. 25 beispielgemäß mit einem gleichen Medium befüllte Strukturinnenräume 16 innerhalb des gesamten Systems und Fig. 26 zeigt hingegen eine mikromechanische Anordnung, deren Strukturräume selektiv befüllt sind.

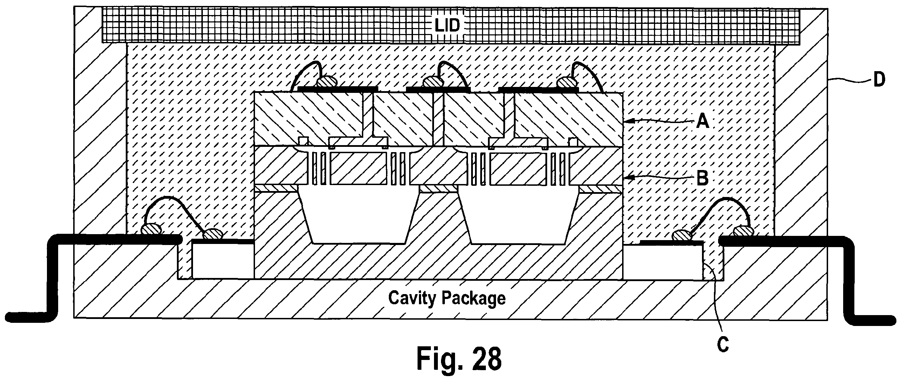

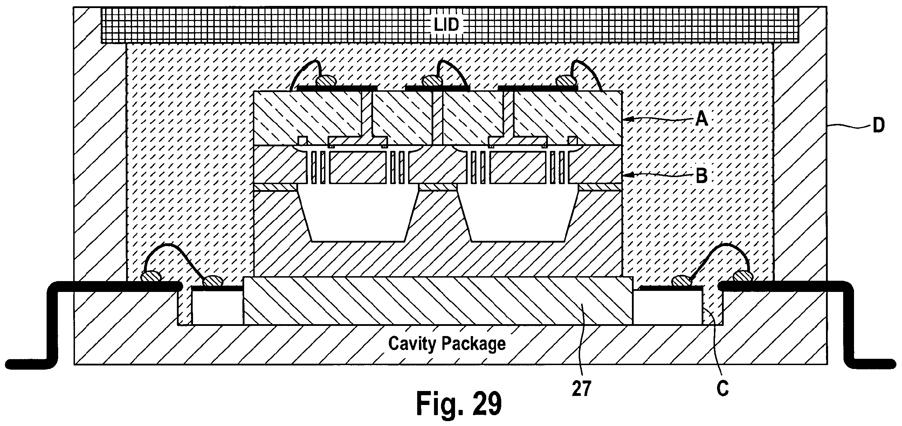

Fig. 27, 28 und 29 zeigen beispielhafte mikromechanische Anordnungen von verkapselten Strukturen inklusive Regelungs- und Signalauswerteschaltung (ASIC) C in einem vorgeformten Gehäuse D, wobei die verkapselten Strukturen, umfassend ein Strukturmodul B, welches mittels eines Verkapselungsmoduls A verkapselt ist, und der ASIC C mittels Drahtbonden mit den jeweiligen elektrischen Anschlüssen verbunden sind. Die Anordnung von verkapselten Strukturen und insbesondere eines ASICs nebeneinander in einem vorgeformten Gehäuse mit elektrischen Anschlüssen, welche die Signale aus dem ASIC und der verkapselten Struktur außen zugänglich machen und diese mittels Drahtbonden kontaktieren, ist mit der Durchkontaktierungs- und Halbleiter-Leiterbahnen-Technologie des Verkapselungsmoduls A in besonders vorteilhafter Weise möglich. Dabei zeigt Fig. 27 eine Ansicht, bei welcher der ASIC C vor der verkapselten Struktur A,B, angeordnet ist und Fig. 28 eine Ansicht, bei welcher der ASIC C hinter der verkapselten Struktur A, B angeordnet ist. Fig. 29 zeigt eine beispielhafte mikromechanische Anordnung, bei welcher zwischen Gehäuseboden und der verkapselten Struktur A, B eine Zwischenschicht 27 angeordnet ist, welche die verkapselte Struktur mechanisch und thermisch vom Gehäuse entkoppelt.

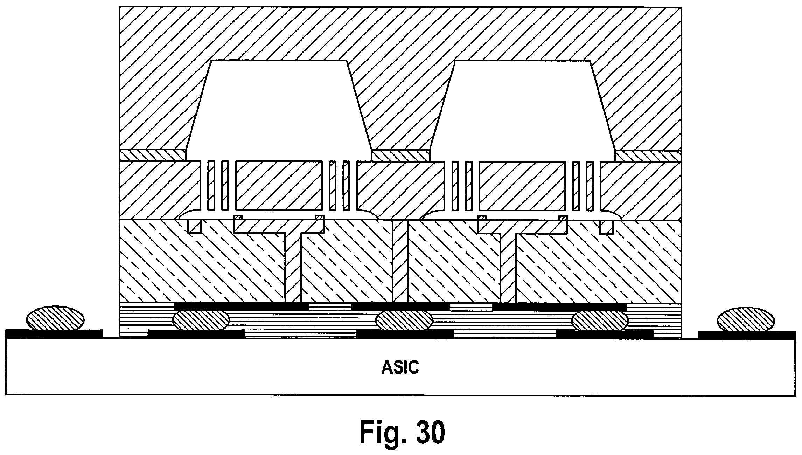

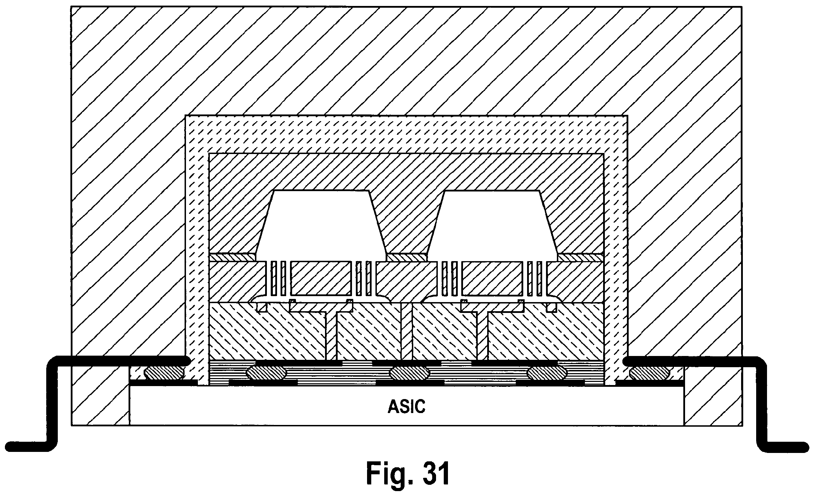

Fig. 30 und 31 veranschaulichen beispielhaft jeweils eine Anordnung von verkapselten Strukturen inklusive Regelungs- und Signalauswerteschaltung (ASIC), bei welcher die verkapselte Struktur mittels Flip-Chip direkt auf dem ASIC angeordnet ist und diese beiden in einem vorgeformten Gehäuse platziert sind. Diese Assemblierung auf dem ASIC mittels Flip-Chip Technologie ist durch Verwendung eines Verkapselungsmoduls mit Durchkontaktierungen und insbesondere Halbleiter-Leiterbahnen möglich. Zwischen ASIC und verkapselter Struktur befindet sich beispielhaft ein Einbettungsmaterial (under-fill) zum mechanischen Fixieren, zur Schwingungsdämpfung und zum Schutz der elektrischen Kontakte, beispielsweise gegen Partikel, dem Vergussmaterial oder Feuchtigkeit. Fig. 31 stellt eine entsprechende beispielhafte Anordnung in einem Cavity-Gehäuse dar, welches beispielgemäß mit einem Gel gefüllt ist. Die Kontaktierung zwischen der verkapselten Struktur und dem ASIC, sowie dem ASIC und nach außen geführten Kontakten ist beispielgemäß über Lötperlen bzw. Ball-Grids realisiert.

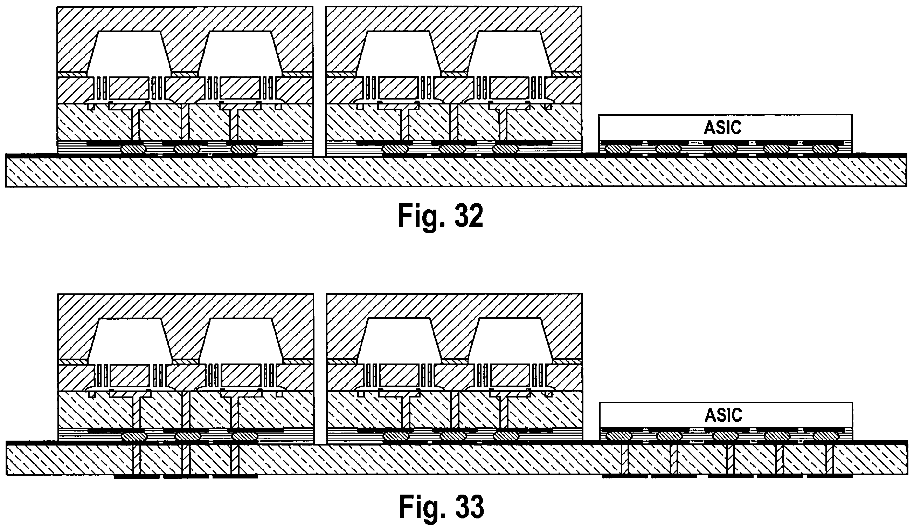

Fig. 32 und 33 zeigen beispielhafte mikromechanische Anordnungen, die mehrere verkapselte Strukturen und mindestens einen ASIC aufweisen. Dabei sind diese Bauteile in Fig. 32 auf einem einfachen Siliziumwafer und in Fig. 33 auf einem Verkapselungsmodul bzw. einem entsprechenden Verkapselungswafer mit Durchkontaktierungen angeordnet. In Fig. 33 sind die Bauteile direkt mit dem Verkapselungsmodul, auf welchem sie angeordnet sind, über Durchkontaktierungen elektrisch leitend verbunden.

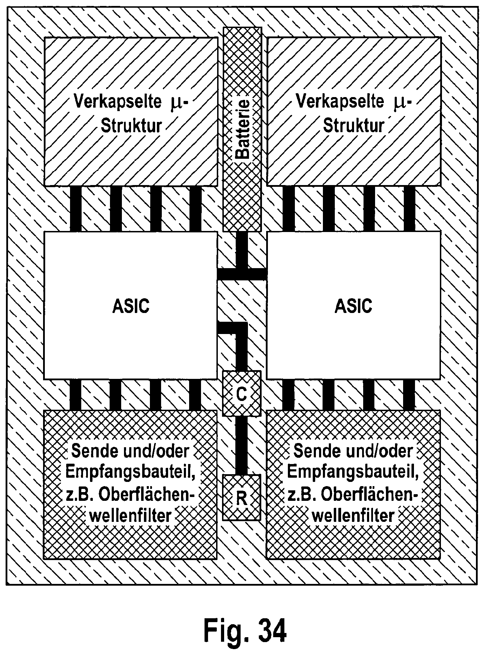

In Fig. 34 ist ein Ausführungsbeispiel eines Systems bzw. einer Bauteilanordnung auf einem Verkapselungsmodul, mit Durchkontaktierungen und Halbleiter-Leiterbahnebenen sowie beispielgemäß drahtlosen Sende- und Empfangsbauelementen (OWF), inklusive einer Batterie zur Energieversorgung, dargestellt.

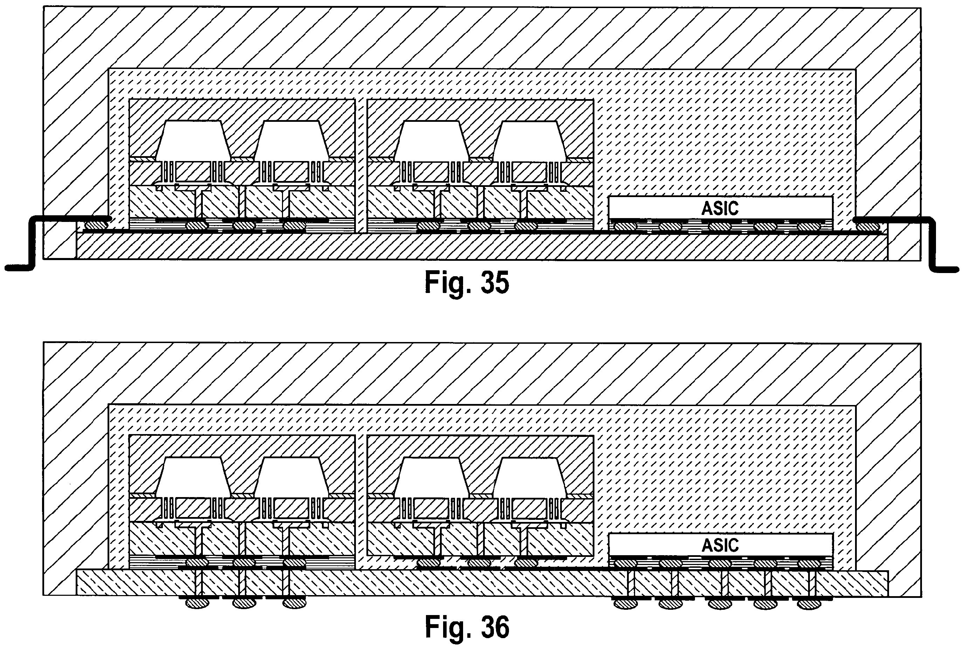

Fig. 35 zeigt ein Ausführungsbeispiel einer Verpackungsanordnung eines Chip-Stack in einem einfachen Cavity-Gehäuse. Die elektrischen Kontakte des Chip-Stack sind mittels Flip-Chip Technologie mit dem Träger verbunden. Dieser Träger bzw. Trägerwafer schließt das Gehäuse als Boden ab.

Fig. 36 zeigt eine beispielhafte Ausführung, in welcher ein Verkapselungsmodul mit Durchkontaktierungen als Trägermodul für die Bauelemente und Gehäuseboden verwendet wird. So können die Chips-Stacks im Gehäuse mittels Lötperlen bzw. Ball-Grid-Arrays direkt auf das als Gehäuseboden verwendete Verkapselungsmodul angeordnet und mit diesem elektrisch verbunden werden und diese Anordnung auf einer nicht dargestellten elektronischen Leiterplatte montiert und an diese mittels an den Durchkontaktierungen angebrachten Lötperlen bzw. Ball-Grid-Arrays angeschlossen werden. Dabei wirkt sich die selbst justierende Wirkung beim Löten des Ball-Grid-Arrays zu den Lötpads des darunter liegenden Trägermaterials positiv auf die Genauigkeit des Gesamtsystems aus. Als Gehäuse kann beispielsweise ein vorgeformtes Plastik- oder Metallgehäuse oder ein MID-Package verwendet werden. Die Anbindung des Gehäuses an das Verkapselungsmodul mit Durchkontaktierungen erfolgt beispielgemäß durch Kleben oder alternativ beispielhaft durch Laserschweißen. Der freie Innenraum ist beispielhaft durch Gel aufgefüllt.

Solche Anordnungen von verkapselten Strukturen können auch auf einem Leadframe direkt mit Kunststoff umspritzt werden.

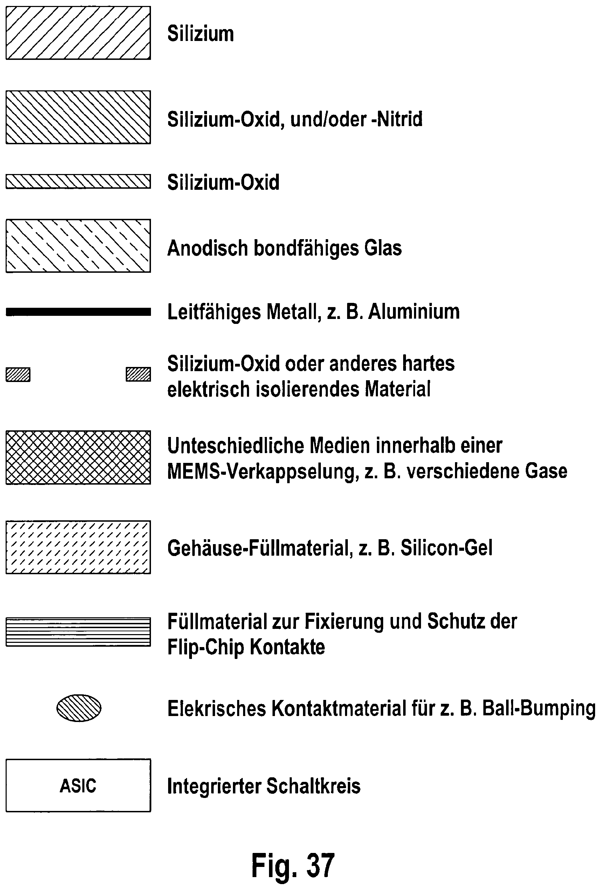

In Fig. 37 sind insbesondere bestimmten Mustern, welche in obigen Figuren vorkommen, beispielhafte Bedeutungen zugewiesen, wodurch Fig. 37 eine beispielgemäße Legende für obig beschriebene Figuren bildet.

Die in den Figuren dargestellten Beispiele sowie die zusätzlich vorgeschlagenen Ausführungsformen betreffen insbesondere alle Weiterbildungen des Herstellungsverfahrens als auch das durch dieses jeweilige Verfahren hergestellte Verkapselungsmodul oder die mikromechanische Anordnung.

## Patentansprüche

1. Verfahren zur Herstellung eines Verkapselungsmoduls (A) **oder** zur Verkapselung einer mikromechanischen Anordnung, wobei die mikromechanische Anordnung zumindest ein Strukturmodul und zumindest ein Verkapselungsmodul (A) aufweist,
wobei aus einem Rohkörper (1) elektrisch leitenden Halbleitermaterials, insbesondere aus dotierten Silizium, elektronische Anschlussmittel, wie Durchkontaktierungen (2), elektrische Leitungen, Kontakte und/oder elektronische Strukturen, durch einen oder mehrere Strukturierungsprozesse und/oder Ätzprozesse ausgebildet werden, wobei im Zuge der Ausbildung der elektronischen Anschlussmittel ein Sockel (6) des Halbleitermaterials entsteht, auf welchem die elektronischen Anschlussmittel angeordnet sind, wobei diese anschließend mit einem Einbettungsmaterial (9) eingebettet werden und das Einbettungsmaterial und/oder der Halbleitersockel (6) nach dem Einbetten soweit entfernt werden, dass eine definierte Anzahl der elektronischen Anschlussmittel elektrische Kontakte an mindestens einer der Außenflächen (7, 8) des so hergestellten Verkapselungsmoduls (A) aufweist, **dadurch gekennzeichnet, dass**
im Zuge der Ausbildung der elektronischen Anschlussmittel, durch den mindestens einen Strukturierungs- und/oder Ätzprozess, auf dem Sockel des Halbleitermaterials (6), mindestens ein inselförmiger Materialhügel, auf dem/denen insbesondere jeweils eine Durchkontaktierung (2) angeordnet ist, ausgebildet wird, welcher eine Halbleiter-Elektrode (3) verkörpert.

2. Verfahren nach Anspruch 1, **dadurch gekennzeichnet, dass** während des Einbettens der elektronischen Anschlussmittel mit dem Einbettungsmaterial (9) und/oder während des anschließenden Aushärtens des Einbettungsmaterials, das Einbettungsmaterial (9) zu einem im Wesentlichen scheibenförmigen Körper (20) ausgebildet wird, in welchem die elektronischen Anschlussmittel eingebettet sind, wobei der Einbettungsvorgang insbesondere zumindest einen Gieß- und/oder Schmelzvorgang umfasst.

3. Verfahren nach Ansprüche 1 oder 2, **dadurch gekennzeichnet, dass** mindestens eine der Außenflächen (7, 8) des Verkapselungsmoduls (A) mit wenigstens einem leitfähigen Material (23, 24) beschichtet wird.

4. Verfahren nach mindestens einem der Ansprüche 1 bis 3, **dadurch gekennzeichnet, dass** auf mindestens einer Außenfläche (7, 8) des Verkapselungsmoduls (A) elektronische und/oder mechanische Mittel, wie elektrische Kontaktelemente, Pufferelemente (11) oder Kavitäten (12), zum passgenauen Anschluss des Verkapselungsmoduls (A) an mindestens eine mikromechanische Struktur (B, B1) und/oder mindestens ein weiteres mikromechanisches Modul aufgebracht werden.

5. Verfahren nach mindestens einem der Ansprüche 1 bis 4, **dadurch gekennzeichnet, dass** Glas als Einbettungsmaterial (9) verwendet wird und dass das Glas über den elektronischen Anschlussmitteln schmelzend vergossen oder als flüssiges Glas direkt vergossen und anschließend ausgehärtet wird.

6. Verfahren nach mindestens einem der Ansprüche 1 bis 5, **dadurch gekennzeichnet, dass** durch wenigstens einen Strukturierungsprozess und/oder Ätzprozess mindestens ein Tunnel (13) zwischen zumindest zwei, insbesondere gegenüberliegenden, Außenflächen (7, 8) des Verkapselungsmoduls (A) erzeugt wird.

7. Verfahren nach Anspruch 6, **dadurch gekennzeichnet, dass** der mindestens eine Tunnel (13) durch Entfernen wenigstens einer Durchkontaktierung (2) erzeugt wird.

8. Verfahren nach mindestens einem der Ansprüche 1 bis 7, **dadurch gekennzeichnet, dass** mindestens eine zusätzliche mikromechanische Struktur (B, B1) durch das Verkapselungsmodul (A), insbesondere hermetisch, verkapselt wird, wobei, insbesondere vorher, mindestens eine elektrische Durchkontaktierung (2) des Verkapselungsmoduls, insbesondere mittels eines Ätzprozesses, entfernt wird, wodurch ein Tunnel (13) durch das Verkapselungsmodul (A) in den Innenraum (12, 16) der entsprechenden mikromechanischen Struktur (B, B1) entsteht, und nachfolgend durch diese/n Tunnel (13), insbesondere jeweils, ein definiertes Medium mit im Wesentlichen definiertem Druck in den jeweiligen Innenraum (12, 16) der entsprechenden mikromechanischen Struktur (B, B1) eingebracht wird.

9. Verfahren nach Anspruch 8, **dadurch gekennzeichnet, dass** der mindestens ein Tunnel (13) anschließend verschlossen wird.

10. Verfahren nach Anspruch 9, **dadurch gekennzeichnet, dass** das anschließende Verschließen des mindestens einen Tunnels (13) durch Einbringen eines Einbettungs- und/oder Vergussmaterials in diesen mindestens einen Tunnel und danach erfolgendem Aushärten dieses in den Tunnel eingebrachten Materials, durchgeführt wird.

11. Verkapselungsmodul (A), insbesondere zur Verkapselung mikromechanischer Strukturen, oder mikromechanische Anordnung mit zumindest einem Strukturmodul und zumindest einem Verkapselungsmodul (A), insbesondere hergestellt entsprechend einem Verfahren gemäß mindestens einem der Ansprüche 1 bis 10, welches einen im Wesentlichen scheibenförmigen Körper (20) aus elektrisch isolierendem Einbettungsmaterial und zumindest eine elektrische Durchkontaktierung (2) aus elektrisch leitendem Halbleitermaterial umfasst, welche in dem scheibenförmig ausgebildeten Körper (20) eingebettet ist und dabei so ausgebildet und angeordnet ist, dass sie zwei elektrische Kontakte auf den beiden, gegenüberliegenden, äußeren Basisflächen (7, 8), also der Grundfläche (7) und der Deckfläche (8) des scheibenförmigen Körpers (20), miteinander elektrisch leitend verbindet,
wobei das Verkapselungsmodul (A) oder die mikromechanische Anordnung wenigstens eine Elektrode (3) aus elektrisch leitendem Halbleitermaterial aufweist, **dadurch gekennzeichnet,**
**dass** die wenigstens eine Elektrode (3) aus elektrisch leitendem Halbleitermaterial eine Grenzfläche mit einer der Basisflächen (7, 8) des scheibenförmig ausgebildeten Körpers (20) aus Einbettungsmaterial (9) aufweist und im Wesentlichen hügelförmig in den scheibenförmig ausgebildeten Körper (20) ausgedehnt ausgebildet ist und innerhalb dieses Körpers mit einer Durchkontaktierung (2) einstückig verbunden ist.

12. Verkapselungsmodul oder mikromechanische Anordnung nach Anspruch 11, **dadurch gekennzeichnet, dass** zumindest eine Halbleiter-Elektrode (3) als elektrisch leitfähige Fläche, insbesondere Kondensatorplatte, einer mikromechanischen Ausleseeinrichtung und/oder Anrege-/Antriebseinrichtung oder als elektrisches Anschlussmittel ausgelegt ist.

13. Verkapselungsmodul oder mikromechanische Anordnung nach mindestens einem der Ansprüche 11 bis 12, **dadurch gekennzeichnet, dass** der scheibenförmig ausgebildete Körper (20) mindestens einen Tunnel (13, 14) zwischen den beiden äußeren Basisflächen (7, 8) aufweist, wobei dieser wenigstens eine Tunnel (13, 14) offen oder mit Einbettungsmaterial oder einem anderen Material verschlossen ist.

14. Verkapselungsmodul oder mikromechanische Anordnung nach mindestens einem der Ansprüche 11 bis 13, **dadurch gekennzeichnet, dass** als Einbettungsmaterial Glas oder ein polymeres Material, insbesondere Harz, verwendet wird.

15. Verkapselungsmodul oder mikromechanische Anordnung nach mindestens einem der Ansprüche 11 bis 14, **dadurch gekennzeichnet, dass** der scheibenförmig ausgebildete Körper (20) an mindestens einer Stelle, auf mindestens einer der beiden äußeren Basisflächen (7, 8), mit einem leitfähigen Material (23, 24) beschichtet ist.

16. Verkapselungsmodul oder mikromechanische Anordnung nach mindestens einem der Ansprüche 11 bis 15, **dadurch gekennzeichnet, dass** diese/s mindestens eine Leiterbahn (4) aus elektrisch leitendem Halbleitermaterial aufweist, welche mit einer Basisfläche (7, 8) eine gemeinsame Leiterbahnfläche aufweist und insbesondere entsprechend der mindestens einen Halbleiter-Elektrode (3) ausgebildet ist.

17. Verkapselungsmodul oder mikromechanische Anordnung nach mindestens einem der Ansprüche 11 bis 16, **dadurch gekennzeichnet, dass** der scheibenförmig ausgebildete Körper (20) an mindestens einer der beiden äußeren Basisflächen (7,8) mindestens ein mikromechanisches Mittel, wie ein Pufferelement (11) oder eine Kavität (12), zum Zusammenwirken mit zusätzlichen mikromechanischen Strukturen (B, B1), aufweist.

18. Verkapselungsmodul oder mikromechanische Anordnung nach mindestens einem der Ansprüche 11 bis 17, **dadurch gekennzeichnet, dass** der scheibenförmig ausgebildete Körper (20) mit mindestens einer zusätzlichen mikromechanischen Struktur (B, B1) so verbunden ist, dass dieser die zusätzliche/n mikromechanische/n Struktur/en, insbesondere hermetisch, verkapselt und dass elektrische Anschlüsse und/oder Kontakte der zusätzlichen mikromechanischen Struktur/en mit einer oder mehreren Durchkontaktierungen (2) und/oder Halbleiter-Elektroden (3) und/oder Halbleiter-Leiterbahnen (4), welche in dem scheibenförmig ausgebildeten Körper (20) eingebettet sind, elektrisch leitend verbunden sind und/oder elektrisch zusammenwirken.

19. Verkapselungsmodul oder mikromechanische Anordnung nach Anspruch 17 und 18, **dadurch gekennzeichnet, dass** das mindestens eine mikromechanische Mittel (11, 12), auf mindestens einer der beiden äußeren Basisflächen (7, 8) des scheibenförmig ausgebildeten Körpers (20) so angeordnet und ausgebildet ist, dass dieses/diese mit den mikromechanischen Mitteln der mindestens einen zusätzlichen mikromechanischen Struktur (B, B1), wie Membranen oder Biegebalken, zusammenwirken kann/ können.

20. Verkapselungsmodul oder mikromechanische Anordnung nach Anspruch 18 oder 19, **dadurch gekennzeichnet, dass** die mindestens eine zusätzliche mikromechanische Struktur (B, B1) über die mindestens eine elektrische Durchkontaktierung (2) und/oder eine Halbleiter-Elektrode (3) und/oder eine Halbleiter-Leiterbahn (4), welche in dem scheibenförmig ausgebildeten Körper (20) eingebettet ist/sind, an mindestens eine externe, insbesondere integrierte, elektronische Schaltung (C) elektrisch angeschlossen ist/sind.

21. Verkapselungsmodul oder mikromechanische Anordnung nach Anspruch 20, **dadurch gekennzeichnet, dass** die mindestens eine zusätzliche mikromechanische Struktur (B, B1) über den scheibenförmig ausgebildeten Körper (20) mit mindestens einer, insbesondere auf einem Chip, integrierten Schaltung (C) mechanisch verbunden ist/sind.

22. Verkapselungsmodul oder mikromechanische Anordnung nach mindestens einem der Ansprüche 11 bis 17, **dadurch gekennzeichnet, dass** der scheibenförmig ausgebildete Körper (20) mechanisch und/oder mittels einer oder mehrerer Durchkontaktierungen (2) und/oder Halbleiter-Elektroden (3) und/oder Halbleiter-Leiterbahnen (4), elektrisch leitend mit mindestens einer zusätzlichen mikromechanischen Struktur (B2) und/oder mindestens einer zusätzlichen mikromechanischen Anordnung und/oder mindestens einer, insbesondere auf einem Chip angeordneten, integrierten Schaltung (C), insbesondere mittels zusätzlicher Lötperlen, verbunden ist.

23. Verkapselungsmodul oder mikromechanische Anordnung nach Anspruch 22, **dadurch gekennzeichnet, dass** die mindestens eine zusätzliche mikromechanische Struktur (B, B1) und/oder die mindestens eine zusätzliche mikromechanische Anordnung und/oder die mindestens eine, insbesondere auf einem Chip, integrierte Schaltung (C) mit einer Basisfläche (7, 8) des scheibenförmig ausgebildeten Körpers (20) mechanisch und/oder elektrisch leitend mittels wenigstens einer Durchkontaktierung (2) und/oder Halbleiter-Elektrode (3) und/oder Halbleiter-Leiterbahn (4) verbunden ist und dass die andere Basisfläche (8, 7) des scheibenförmig ausgebildeten Körpers (20) mit einer Leiterplatine (D) oder einer zusätzlichen elektronischen Schaltung oder einem zusätzlichen Verkapselungsmodul, insbesondere über Lötperlen, verbunden ist.

24. Verkapselungsmodul oder mikromechanische Anordnung nach mindestens einem der Ansprüche 11 bis 17, **dadurch gekennzeichnet, dass** der scheibenförmig ausgebildete Körper (20) auf einem Sensorgehäuse als Deckel angeordnet und befestig ist, wobei mindestens eine im Sensorgehäuse angeordnete elektronische Schaltung (C) und/oder mindestens ein elektronisches Bauelemente und/oder mindestens eine mikromechanische Struktur (B, B1) über die mindestens eine, in dem scheibenförmig ausgebildeten Körper (20) eingebettete, elektrische Durchkontaktierung (2) und/oder Halbleiter-Elektrode (3) und/oder Halbleiter-Leiterbahn (4) an mindestens eine externe elektronische Schaltung (C) elektrisch leitend angeschlossen ist.

25. Verwendung des Verkapselungsmoduls und/oder der mikromechanischen Anordnung gemäß mindestens einem der Ansprüche 11 bis 24 in einem Kraftfahrzeug, insbesondere in einem Kraftfahrzeugregelungssystem.

## Claims

1. Method for producing an encapsulation module (A) or for encapsulating a micromechanical arrangement, wherein the micromechanical arrangement has at least one structure module and at least one encapsulation module (A), wherein electronic connection means such as plated-through holes (2), electrical lines, contacts and/or electronic structures are formed from a blank (1) of electrically conductive semiconductor material, in particular composed of doped silicon, by means of one or more structuring processes and/or etching processes, wherein, in the course of forming the electronic connection means, a pedestal (6) of the semiconductor material arises, on which the electronic connection means are arranged, wherein the latter are subsequently embedded with an embedding material (9) and the embedding material and/or the semiconductor pedestal (6) are removed after the embedding to an extent such that a defined number of the electronic connection means have electrical contacts on at least one of the outer surfaces (7, 8) of the encapsulation module (A) thus produced, **characterized in that**
in the course of forming the electronic connection means, by means of the at least one structuring and/or etching process, on the pedestal of the semiconductor material (6) at least one insular material hump is formed, on which in particular a plated-through hole (2) is arranged in each case, and which embodies a semiconductor electrode (3).

2. Method according to Claim 1, **characterized in that** during the embedding of the electronic connection means with the embedding material (9) and/or during the subsequent hardening of the embedding material, the embedding material (9) is formed into a substantially disk-shaped body (20) in which the electronic connection means are embedded, wherein the embedding process comprises in particular at least one casting and/or melting process.

3. Method according to Claim 1 or 2,
**characterized in that** at least one of the outer surfaces (7, 8) of the encapsulation module (A) is coated with at least one conductive material (23, 24).

4. Method according to at least one of Claims 1 to 3, **characterized in that** electronic and/or mechanical means such as electrical contact elements, buffer elements (11) or cavities (12) are applied on at least one outer surface (7, 8) of the encapsulation module (A), for the accurately fitting connection of the encapsulation module (A) to at least one micromechanical structure (B, B1) and/or at least one further micromechanical module.

5. Method according to at least one of Claims 1 to 4, **characterized in that** glass is used as the embedding material (9), and **in that** the glass is potted in liquescent fashion over the electronic connection means or is potted directly as liquid glass and is subsequently hardened.

6. Method according to at least one of Claims 1 to 5, **characterized in that** at least one tunnel (13) is produced between at least two, in particular opposite, outer surfaces (7, 8) of the encapsulation module (A) by means of at least one structuring process and/or etching process.

7. Method according to Claim 6, **characterized in that** the at least one tunnel (13) is produced by removing at least one plated-through hole (2).

8. Method according to at least one of Claims 1 to 7, **characterized in that** at least one additional micromechanical structure (B, B1) is encapsulated, in particular hermetically, by the encapsulation module (A), wherein, in particular beforehand, at least one electrical plated-through hole (2) of the encapsulation module is removed, in particular by means of an etching process, whereby a tunnel (13) through the encapsulation module (A) into the interior (12, 16) of the corresponding micromechanical structure (B, B1) arises, and afterward, through said tunnel(s) (13), in particular in each case, a defined medium with a substantially defined pressure is introduced into the respective interior (12, 16) of the corresponding micromechanical structure (B, B1).

9. Method according to Claim 8, **characterized in that** the at least one tunnel (13) is subsequently closed off.

10. Method according to Claim 9, **characterized in that** the subsequent closing off of the at least one tunnel (13) is carried out by introducing an embedding and/or potting material into said at least one tunnel and subsequently hardening this material introduced into the tunnel.

11. Encapsulation module (A), in particular for encapsulating micromechanical structures, or micromechanical arrangement having at least one structure module and at least one encapsulation module (A), in particular produced in accordance with a method according to at least one of Claims 1 to 10, which comprises a substantially disk-shaped body (20) composed of electrically insulating embedding material and at least one electrical plated-through hole (2) composed of electrically conductive semiconductor material which is embedded in the disk-shapedly formed body (20) and in this case is formed and arranged such that it electrically conductively connects two electrical contacts on the two, opposite, outer base surfaces (7, 8) that is to say the bottom surface (7) and the top surface (8) of the disk-shaped body (20), to one another, wherein the encapsulation module (A) or the micromechanical arrangement has at least one electrode (3) composed of electrically conductive semiconductor material, **characterized in that** the at least one electrode (3) composed of electrically conductive semiconductor material has an interface with one of the base surfaces (7, 8) of the disk-shapedly formed body (20) composed of embedding material (9) and is formed in a manner extended substantially in mound-shaped fashion into the disk-shapedly formed body (20) and is connected to a plated-through hole (2) within said body.

12. Encapsulation module or micromechanical arrangement according to Claim 11, **characterized in that** at least one semiconductor electrode (3) is designed as an electrically conductive surface, in particular a capacitor plate, of a micromechanical read-out device and/or excitation/drive device or as an electrical connection means.

13. Encapsulation module or micromechanical arrangement according to at least one of Claims 11 to 12, **characterized in that** the disk-shapedly formed body (20) has at least one tunnel (13, 14) between the two outer base surfaces (7, 8), wherein said at least one tunnel (13, 14) is opened or closed off with embedding material or some other material.

14. Encapsulation module or micromechanical arrangement according to at least one of Claims 11 to 13, **characterized in that** glass or a polymeric material, in particular resin, is used as the embedding material.

15. Encapsulation module or micromechanical arrangement according to at least one of Claims 11 to 14, **characterized in that** the disk-shapedly formed body (20) is coated with a conductive material (23, 24) at at least one location, on at least one of the two outer base surfaces (7, 8).

16. Encapsulation module or micromechanical arrangement according to at least one of Claims 11 to 15, **characterized in that** said module and/or arrangement has at least one interconnect (4) composed of electrically conductive semiconductor material which, with a base surface (7, 8), has a common interconnect surface and is formed in particular in a manner corresponding to the at least one semiconductor electrode (3).

17. Encapsulation module or micromechanical arrangement according to at least one of Claims 11 to 16, **characterized in that** the disk-shapedly formed body (20) has, on at least one of the two outer base surfaces (7, 8), at least one micromechanical means, such as a buffer element (11) or a cavity (12), for interaction with additional micromechanical structures (B, B1).

18. Encapsulation module or micromechanical arrangement according to at least one of Claims 11 to 17, **characterized in that** the disk-shapedly formed body (20) is connected to at least one additional micromechanical structure (B, B1) in such a way that it encapsulates, in particular hermetically, the additional micromechanical structure(s), and that electrical connections and/or contacts of the additional micromechanical structure(s) are electrically conductively connected to and/or electrically interact with one or more plated-through holes (2) and/or semiconductor electrodes (3) and/or semiconductor interconnects (4) which are embedded in the disk-shapedly formed body (20).

19. Encapsulation module or micromechanical arrangement according to Claims 17 and 18, **characterized in that** the at least one micromechanical means (11, 12), on at least one of the two outer base surfaces (7, 8) of the disk-shapedly formed body (20), is arranged and formed in such a way that said means can interact with the micromechanical means of the at least one additional micromechanical structure (B, B1), such as membranes or bending beams.

20. Encapsulation module or micromechanical arrangement according to Claim 18 or 19, **characterized in that** the at least one additional micromechanical structure (B, B1) is/are electrically connected to at least one external, in particular integrated, electronic circuit (C) via the at least one electrical plated-through hole (2) and/or a semiconductor electrode (3) and/or a semiconductor interconnect (4) which is/are embedded in the disk-shapedly formed body (20) .

21. Encapsulation module or micromechanical arrangement according to Claim 20, **characterized in that** the at least one additional micromechanical structure (B, B1) is/are mechanically connected to at least one integrated circuit (C), in particular integrated on a chip, via the disk-shapedly formed body (20) .

22. Encapsulation module or micromechanical arrangement according to at least one of Claims 11 to 17, **characterized in that** the disk-shapedly formed body (20) is connected mechanically and/or - by means of one or more plated-through holes (2) and/or semiconductor electrodes (3) and/or semiconductor interconnects (4) - electrically conductively to at least one additional micromechanical structure (B2) and/or at least one additional micromechanical arrangement and/or at least one integrated circuit (C), in particular arranged on a chip, in particular by means of additional soldering beads.

23. Encapsulation module or micromechanical arrangement according to Claim 23, **characterized in that** the at least one additional micromechanical structure (B, B1) and/or the at least one additional micromechanical arrangement and/or the at least one integrated circuit (C), in particular integrated on a chip, is connected to one base surface (7, 8) of the disk-shapedly formed body (20) mechanically and/or electrically conductively by means of at least one plated-through hole (2) and/or semiconductor electrode (3) and/or semiconductor interconnect (4), and **in that** the other base surface (8, 7) of the disk-shapedly formed body (20) is connected to a printed circuit board (D) or an additional electronic circuit or an additional encapsulation module, in particular by means of soldering beads.

24. Encapsulation module or micromechanical arrangement according to at least one of Claims 11 to 17, **characterized in that** the disk-shapedly formed body (20) is arranged and fixed as a cover on a sensor housing, wherein at least one electronic circuit (C) arranged in the sensor housing and/or at least one electronic component and/or at least one micromechanical structure (B, B1) is electrically conductively connected to at least one external electronic circuit (C) via the at least one electrical plated-through hole (2) and/or semiconductor electrode (3) and/or semiconductor interconnect (4) embedded in the disk-shapedly formed body (20).

25. Use of the encapsulation module and/or of the micromechanical arrangement according to at least one of Claims 11 to 24 in a motor vehicle, in particular in a motor vehicle control system.

## Revendications

1. Procédé de fabrication d'un module d'encapsulation (A) ou d'encapsulation d'un arrangement micromécanique, l'arrangement micromécanique possédant au moins un module de structure et au moins un module d'encapsulation (A),
des moyens de raccordement électroniques, comme des connexions traversantes (2), des lignes électriques, des contacts et/ou des structures électroniques étant formés à partir d'un corps brut (1) de matériau semiconducteur électriquement conducteur, notamment en silicium dopé, par un ou plusieurs processus de structuration et/ou de gravure,
un socle (6) du matériau semiconducteur étant obtenu au cours de la formation des moyens de raccordement électroniques, sur lequel sont disposés les moyens de raccordement électroniques, ceux-ci étant ensuite enrobés dans un matériau d'enrobage (9) et le matériau d'enrobage et/ou le socle en semiconducteur (6) étant retirés après l'enrobage dans une mesure où un nombre défini des moyens de raccordement électroniques possède des contacts électriques sur au moins l'une des surfaces extérieures (7, 8) du module d'encapsulation (A) ainsi fabriqué,
**caractérisé en ce que**
au cours de la formation des moyens de raccordement électroniques, au moins un cône de matériau en forme d'île, lequel incarne une électrode en semiconducteur (3), est formé sur le socle du matériau semiconducteur (6) par l'au moins un processus de structuration et/ou de gravure et sur lequel est respectivement disposé au moins une connexion traversante (2).

2. Procédé selon la revendication 1, **caractérisé en ce que** pendant l'enrobage des moyens de raccordement électroniques avec le matériau d'enrobage (9) et/ou pendant le durcissement qui suit du matériau d'enrobage, le matériau d'enrobage (9) est configuré en un corps (20) sensiblement en forme de disque dans lequel sont enrobés les moyens de raccordement électroniques, l'opération d'enrobage comprenant notamment au moins une opération de coulée et/ou de fusion.

3. Procédé selon l'une des revendications 1 et 2, **caractérisé en ce qu'**au moins l'une des surfaces extérieures (7, 8) du module d'encapsulation (A) est revêtue d'au moins un matériau conducteur (23, 24).

4. Procédé selon au moins l'une des revendications 1 à 3, **caractérisé en ce que** des moyens électroniques et/ou mécaniques, tels que des éléments de contact électrique, des éléments formant tampon (11) ou des cavités (12) servant au raccordement avec ajustement serré du module d'encapsulation (A) à au moins une structure micromécanique (B, Bl) et/ou à au moins un module micromécanique supplémentaire sont appliqués sur au moins une surface extérieure (7, 8) du module d'encapsulation (A) .

5. Procédé selon au moins l'une des revendications 1 à 4, **caractérisé en ce que** du verre est utilisé comme matériau d'enrobage (9) et **en ce que** le verre est coulé en fusion sur les moyens de raccordement électroniques ou directement coulé sous forme de verre liquide et ensuite durci.

6. Procédé selon au moins l'une des revendications 1 à 5, **caractérisé en ce qu'**au moins un tunnel (13) est produit entre au moins deux surfaces extérieures (7, 8), de préférence opposées, du module d'encapsulation (A) par au moins un processus de structuration et/ou de gravure.

7. Procédé selon la revendication 6, **caractérisé en ce que** l'au moins un tunnel (13) est produit par enlèvement d'au moins une connexion traversante (2).

8. Procédé selon au moins l'une des revendications 1 à 7, **caractérisé en ce qu'**au moins une structure micromécanique (B, Bl) supplémentaire est encapsulée, notamment hermétiquement, par le module d'encapsulation (A), au moins une connexion traversante (2) électrique du module d'encapsulation étant retirée, notamment préalablement, notamment au moyen d'un processus de gravure, un tunnel (13) étant ainsi produit à travers le module d'encapsulation (A) dans l'espace intérieur (12, 16) de la structure micromécanique (B, Bl) correspondante, et un fluide défini ayant une pression sensiblement définie étant ensuite introduit à travers ce/ces tunnel (s) (13), notamment respectivement, dans l'espace intérieur (12, 16) correspondant de la structure micromécanique (B, Bl) correspondante.

9. Procédé selon la revendication 8, **caractérisé en ce que** l'au moins un tunnel (13) est ensuite fermé.

10. Procédé selon la revendication 9, **caractérisé en ce que** la fermeture postérieure de l'au moins un tunnel (13) est effectuée par introduction d'un matériau d'enrobage et/ou de scellement dans ledit au moins un tunnel et ensuite la réalisation d'un durcissement de ce matériau introduit dans le tunnel.

11. Module d'encapsulation (A), notamment destiné à l'encapsulation de structures micromécaniques, ou arrangement micromécanique comprenant au moins un module de structure et au moins un module d'encapsulation (A), notamment fabriqué conformément à un procédé selon au moins l'une des revendications 1 à 10, lequel comprend un corps (20) sensiblement en forme de disque en matériau d'enrobage électriquement isolant et au moins une connexion traversante (2) en matériau semiconducteur électriquement conducteur, laquelle est enrobée dans le corps (20) configuré en forme de disque et est ici configurée et formée de telle sorte qu'elle relie de manière électriquement conductrice entre eux deux contacts électriques sur les surfaces de base extérieures (7, 8) opposées, c'est-à-dire la surface de base (7) et la surface de recouvrement (8), du corps (20) en forme de disque,
le module d'encapsulation (A) ou l'arrangement micromécanique possédant au moins une électrode (3) en matériau semiconducteur électriquement conducteur, **caractérisé en ce que**
l'au moins une électrode (3) en matériau semiconducteur électriquement conducteur possède une interface avec l'une des surfaces de base (7, 8) du corps (20) configuré en forme de disque en matériau d'enrobage (9) et elle est configurée étendue sensiblement en forme de cône dans le corps (20) configuré en forme de disque et reliée d'un seul tenant à une connexion traversante (2) à l'intérieur de ce corps.

12. Module d'encapsulation ou arrangement micromécanique selon la revendication 11, **caractérisé en ce qu'**au moins une électrode en semiconducteur (3) est conçue sous la forme d'une surface électriquement conductrice, notamment une plaque de condensateur, d'un dispositif de lecture micromécanique et/ou d'un dispositif d'excitation/entraînement ou sous la forme d'un moyen de raccordement électrique.

13. Module d'encapsulation ou arrangement micromécanique selon au moins l'une des revendications 11 et 12, **caractérisé en ce que** le corps (20) configuré en forme de disque possède au moins un tunnel (13, 14) entre les deux surfaces de base extérieures (7, 8), l'au moins un tunnel (13, 14) étant ouvert ou fermé avec un matériau d'enrobage ou un autre matériau.

14. Module d'encapsulation ou arrangement micromécanique selon au moins l'une des revendications 11 à 13, **caractérisé en ce que** le matériau d'enrobage utilisé est du verre ou un matériau polymère, notamment de la résine.

15. Module d'encapsulation ou arrangement micromécanique selon au moins l'une des revendications 11 à 14, **caractérisé en ce que** le corps (20) configuré en forme de disque est revêtu d'un matériau conducteur (23, 24) en au moins un endroit sur au moins l'une des deux surfaces de base extérieures (7, 8).

16. Module d'encapsulation ou arrangement micromécanique selon au moins l'une des revendications 11 à 15, **caractérisé en ce que** celui-ci possède au moins une piste conductrice (4) en un matériau semiconducteur électriquement conducteur, laquelle possède une surface de piste conductrice commune avec une surface de base (7, 8) et est notamment configurée conformément à l'au moins une électrode en semiconducteur (3).

17. Module d'encapsulation ou arrangement micromécanique selon au moins l'une des revendications 11 à 16, **caractérisé en ce que** le corps (20) configuré en forme de disque possède au niveau d'au moins l'une des deux surfaces de base extérieures (7, 8) au moins un moyen micromécanique, comme un élément formant tampon (11) ou une cavité (12), destiné à coopérer avec des structures micromécaniques (B, Bl) supplémentaires.

18. Module d'encapsulation ou arrangement micromécanique selon au moins l'une des revendications 11 à 17, **caractérisé en ce que** le corps (20) configuré en forme de disque est relié à au moins une structure micromécanique (B, Bl) supplémentaire de telle sorte que celui-ci encapsule, notamment hermétiquement, la/les structure(s) micromécanique(s) supplémentaire(s), et **en ce que** des raccordements et/ou des contacts électriques de la/des structure(s) micromécanique(s) supplémentaire(s) sont reliés de manière électriquement conductrice et/ou coopèrent électriquement avec une ou plusieurs connexions traversantes (2) et/ou électrodes en semiconducteur (3) et/ou pistes conductrices en semiconducteur (4) qui sont enrobées dans le corps (20) configuré en forme de disque.

19. Module d'encapsulation ou arrangement micromécanique selon les revendications 17 et 18, **caractérisé en ce que** l'au moins un moyen micromécanique (11, 12) est disposé et configuré sur au moins l'une des deux surfaces de base extérieures (7, 8) du corps (20) configuré en forme de disque de telle sorte que celui-ci/ceux-ci peut/peuvent coopérer avec les moyens micromécaniques de l'au moins une structure micromécanique (B, Bl) supplémentaire, comme des membranes ou des barres de flexion.

20. Module d'encapsulation ou arrangement micromécanique selon la revendication 18 ou 19, **caractérisé en ce que** l'au moins une structure micromécanique (B, Bl) supplémentaire est reliée électriquement à au moins un circuit électronique (C) externe, notamment intégré, par le biais de l'au moins une connexion traversante (2) et/ou une électrode en semiconducteur (3) et/ou une piste conductrice en semiconducteur (4) qui est/sont enrobée(s) dans le corps (20) configuré en forme de disque.

21. Module d'encapsulation ou arrangement micromécanique selon la revendication 20, **caractérisé en ce que** l'au moins une structure micromécanique (B, Bl) supplémentaire est reliée mécaniquement par le biais du corps (20) configuré en forme de disque à au moins un circuit intégré (C), notamment sur une puce.

22. Module d'encapsulation ou arrangement micromécanique selon au moins l'une des revendications 11 à 17, **caractérisé en ce que** le corps (20) configuré en forme de disque est relié mécaniquement et/ou de manière électriquement conductrice au moyen d'une ou plusieurs connexions traversantes (2) et/ou électrodes en semiconducteur (3) et/ou pistes conductrices en semiconducteur (4) à au moins une structure micromécanique (B2) supplémentaire et/ou au moins un arrangement micromécanique supplémentaire et/ou au moins un circuit intégré (C), notamment disposé sur une puce, notamment au moyen de perles de brasure supplémentaires.

23. Module d'encapsulation ou arrangement micromécanique selon la revendication 22, **caractérisé en ce que** l'au moins une structure micromécanique (B, Bl) supplémentaire et/ou l'au moins un arrangement micromécanique supplémentaire et/ou l'au moins un circuit intégré (C), notamment disposé sur une puce, sont reliés mécaniquement et/ou de manière électriquement conductrice au moyen d'au moins une connexion traversante (2) et/ou électrode en semiconducteur (3) et/ou piste conductrice en semiconducteur (4) avec une surface de base (7, 8) du corps (20) configuré en forme de disque et **en ce que** l'autre surface de base (8, 7) du corps (20) configuré en forme de disque est reliée à une platine conductrice (D) ou un circuit électronique supplémentaire ou un module d'encapsulation supplémentaire, notamment par le biais de perles de brasure.

24. Module d'encapsulation ou arrangement micromécanique selon au moins l'une des revendications 11 à 17, **caractérisé en ce que** le corps (20) configuré en forme de disque est disposé et fixé sur un boîtier de capteur en tant que couvercle, au moins un circuit électronique (C) et/ou au moins un composant électronique et/ou au moins une structure micromécanique (B, Bl) disposés dans le boîtier de capteur étant reliés de manière électriquement conductrice à au moins un circuit (C) électronique externe par le biais de l'au moins une connexion traversante électrique (2) et/ou électrode en semiconducteur (3) et/ou piste conductrice en semiconducteur (4) enrobées dans le corps (20) configuré en forme de disque.

25. Utilisation du module d'encapsulation et/ou de l'arrangement micromécanique selon au moins l'une des revendications 11 à 24 dans un véhicule automobile, notamment dans un système de régulation de véhicule automobile.
